# EUROPEAN PATENT APPLICATION

(11) **EP 4 657 439 A1**
(43) Date of publication of application: **03.12.2025**
(21) Application number: 24220882.5
(22) Date of filing: 18.12.2024
(51) Int. Cl.: G11C 16/16, G11C 16/32, G11C 11/56, G11C 16/04

(54) **MEMORY DEVICE, A STORAGE DEVICE INCLUDING THE MEMORY DEVICE, AND AN OPERATION METHOD OF THE STORAGE DEVICE**

(30) Priority: 30.05.2024 KR 20240070787; 02.12.2024 US 202418965458
(71) Applicant: Samsung Electronics Co., Ltd., Suwon-si, Gyeonggi-do 16677 (KR)
(72) Inventor: LEE, Seunghan, 16677 Suwon-si, Gyeonggi-do (KR)
(74) Representative: Kuhnen & Wacker Patent- und Rechtsanwaltsbüro PartG mbB

(57) **Abstract**

A memory device including: a memory cell array including a first memory block; a control logic circuit configured to receive an erase command from an external controller and to control an erase operation on the first memory block in response to the erase command; an erase to program interval (EPI) timer configured to begin measuring a first EPI time of the first memory block in response to the erase command; and a memory circuit configured to store an EPI table that stores the first EPI time,
wherein, when the first EPI time exceeds a reference time, the control logic circuit is further configured to provide EPI information to the external controller.

## Description

### CROSS-REFERENCE TO RELATED APPLICATION

This application claims priority under 35 U.S.C. § 119 to Korean Patent Application No. 10-2024-0070787 filed on May 30, 2024, in the Korean Intellectual Property Office, the disclosure of which is incorporated by reference herein in its entirety.

### Technical Field

Embodiments of the present disclosure described herein relate to a semiconductor memory, and more particularly, to a memory device, a storage device including the memory device, and an operation method of the storage device.

### Discussion of Related Art

Semiconductor memory can be classified as either volatile memory, which loses stored data when power is turned off, such as static random access memory (SRAM) or dynamic random access memory (DRAM), or nonvolatile memory, which retains stored data even when power is off, such as flash memory, phase-change RAM (PRAM), magnetic RAM (MRAM), resistive RAM (RRAM), or ferroelectric RAM (FRAM).

Flash memory devices are widely used as a high-capacity storage media. These devices store data by controlling the threshold voltages of memory cells. However, the threshold voltages may fluctuate due to various factors, potentially leading to errors in reading the stored data. As a result, the reliability of the flash memory device may decrease.

### SUMMARY

Embodiments of the present disclosure provide a memory device with improved performance and improved reliability, a storage device including the memory device, and an operation method of the storage device.

According to an embodiment of the present disclosure, there is provided a memory device including: a memory cell array including a first memory block; a control logic circuit configured to receive an erase command from an external controller and to control an erase operation on the first memory block in response to the erase command; an erase to program interval (EPI) timer configured to begin measuring a first EPI time of the first memory block in response to the erase command; and a memory circuit configured to store an EPI table that stores the first EPI time, wherein, when the first EPI time exceeds a reference time, the control logic circuit is further configured to provide EPI information to the external controller.

According to an embodiment of the present disclosure, there is provided a storage device including: a memory device including a first memory block; and a controller configured to control the memory device, wherein the memory device is configured to: perform an erase operation on the first memory block in response to an erase command received from the controller; begin measuring a first EPI time of the first memory block in response to the erase command; and transmit EPI information to the controller when the first EPI time exceeds a reference time, and wherein the controller is further configured to perform a program operation on the first memory block or a close operation on the first memory block in response to the EPI information.

According to an embodiment of the present disclosure, there is provided an operation method of a storage device which includes a memory device and a controller, the method including: transmitting, by the controller, an erase command for a first memory block to the memory device; performing, by the memory device, an erase operation on the first memory block in response to the erase command; starting, by the memory device, to measure a first EPI time of the first memory block; transmitting, by the controller, a program command and data to the memory device; programming, by the memory device, the data in the first memory block in response to the program command; transmitting, by the memory device, EPI information to the controller when the first EPI time exceeds a reference threshold; and performing, by the controller, a program operation or a close operation on the first memory block in response to the EPI information.

According to an embodiment of the present disclosure, there is provided a storage device including: a memory device including a first memory block, and configured to manage a first EPI time of the first memory block; and a controller configured to communicate with the memory device through a command/address channel and an input/output channel, wherein the memory device is configured to: receive a program command through the command/address channel; and program data received through the input/output channel in the first memory block in response to the program command, and wherein, when the first EPI time exceeds a threshold, the memory device is further configured to transmit EPI information to the controller through the command/address channel while the data are being received through the input/output channel.

### BRIEF DESCRIPTION OF THE DRAWINGS

The above and other features of the present disclosure will become more apparent by describing in detail embodiments thereof with reference to the accompanying drawings.
FIG. 1 is a block diagram illustrating a storage system, according to an embodiment of the present disclosure.
FIG. 2 is a block diagram illustrating a controller of FIG. 1.
FIG. 3 is a block diagram illustrating a memory device of FIG. 1.
FIG. 4 is a circuit diagram illustrating a first memory block among a plurality of memory blocks included in a memory cell array of FIG. 3.
FIG. 5 is a diagram illustrating threshold voltage distributions of memory cells of a first memory block of FIG. 4.
FIG. 6 is a flowchart illustrating an operation of a storage device of FIG. 1.
FIGS. 7A and 7B are diagrams for describing operation S150 of FIG. 6.
FIGS. 8A and 8B are diagrams for describing operation S150 of FIG. 6.
FIG. 9 is a flowchart illustrating an operation of a storage device of FIG. 1.
FIG. 10 is a diagram for describing an operation according to the flowchart of FIG. 9.
FIG. 11 is a flowchart illustrating an operation of a memory device of FIG. 1.
FIG. 12 is a diagram for describing an operation according to the flowchart of FIG. 11.
FIG. 13 is a flowchart illustrating an operation of a storage device of FIG. 1.
FIG. 14 is a block diagram illustrating a storage device according to an embodiment of the present disclosure.
FIG. 15 is a timing diagram for describing an operation of a storage device of FIG. 14.
FIG. 16 is a diagram for describing a header of a command/address packet of FIG. 15.
FIG. 17 is a diagram for describing a characteristic of an SCA NAND interface of a storage device of FIG. 14.
FIG. 18 is a flowchart illustrating an operation of a storage device of FIG. 14.
FIG. 19 is timing diagrams for describing operation S1300 and operation S1500 of FIG. 18.
FIG. 20 is a flowchart illustrating an operation of a storage device of FIG. 14.
FIG. 21 is a diagram for describing operation S2400 of FIG. 20.
FIG. 22 is a view for describing a memory device according to an embodiment of the present disclosure.

### DETAILED DESCRIPTION OF THE EMBODIMENTS

Below, embodiments of the present disclosure will be described in detail and clearly to such an extent that one of ordinary skill in the art can implement the present disclosure.

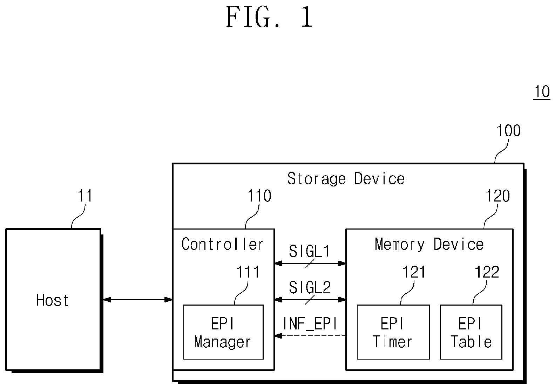

FIG. 1 is a block diagram illustrating a storage system according to an embodiment of the present disclosure. Referring to FIG. 1, a storage system 10 may include a host 11 and a storage device 100. In an embodiment, the storage system 10 may include at least one of various information processing devices such as a personal computer, a laptop computer, a server, a workstation, a smartphone, and a tablet personal computer (PC). Alternatively, the storage system 10 may be configured as a data center for storing and managing various data, or it could be a storage server or an application server within the data center.

The host 11 may be configured to access the storage device 100. For example, based on a given host interface, the host 11 may store data in the storage device 100 or may read data stored in the storage device 100. In an embodiment, the given host interface may include one of various interfaces such as an ATA (Advanced Technology Attachment) interface, a SATA (Serial ATA) interface, an e-SATA (external SATA) interface, an SCSI (Small Computer Small Interface) interface, an SAS (Serial Attached SCSI) interface, a PCI (Peripheral Component Interconnection) interface, a PCIe (PCI express) interface, an NVMe (NVM express) interface, an IEEE 1394 interface, a USB (Universal Serial Bus) interface, an SD (Secure Digital) card interface, an MMC (Multi-Media Card) interface, an eMMC (embedded Multi-Media Card) interface, a UFS (Universal Flash Storage) interface, an eUFS (embedded Universal Flash Storage) interface, and/or a CF (Compact Flash) card interface.

The storage device 100 may operate under control of the host 11. In an embodiment, the storage device 100 may be a high-capacity storage device, which is configured to store data in a computing system, such as a solid state drive (SSD) or a universal flash storage (UFS) card, but the present disclosure is not limited thereto. Alternatively, the storage device 100 may be included in a mobile system such as a mobile phone, a smart phone, a tablet PC, a wearable device, a health care device, or an Internet of things (IOT) device. Alternatively, the storage device 100 may be included in a personal computer, a laptop computer, a server, a media player, or an automotive device such as a navigation system.

The storage device 100 may include a controller 110 and a memory device 120. The controller 110 may control the memory device 120 under control of the host 11. For example, the controller 110 may transmit a command CMD and an address ADDR to the memory device 120 through first signal lines SIGL1 and may exchange data "DATA" with the memory device 120 through the first signal lines SIGL1. In an embodiment, the first signal lines SIGL1 may be data signal lines (e.g., DQ lines). The controller 110 may transmit control signals CTRL to the memory device 120 through second signal lines SIGL2. In an embodiment, the control signals CTRL may be used to classify signals transmitted/received through the first signal lines SIGL1 into the command CMD, the address ADDR, and the data "DATA". However, the present disclosure is not limited thereto.

The memory device 120 may operate under control of the controller 110. For example, in response to signals received from the controller 110, the memory device 120 may store data or may output the stored data. In an embodiment, the memory device 120 may include a flash memory device, but the present disclosure is not limited thereto.

The memory device 120 may include a plurality of memory blocks. Each of the plurality of memory blocks may include a plurality of memory cells. The memory device 120 may store data by controlling threshold voltages of the plurality of memory cells. The threshold voltages of the plurality of memory cells may fluctuate due to various factors, potentially leading to the loss of stored data.

The term "erase to program interval (EPI) time" is used for ease of description. The EPI time indicates an erase left-alone time of a memory block or a time from a point in time when a memory block is erased to a point in time when programming for the erased memory block is completed. In other words, EPI time refers to the duration during which a memory block remains idle after being erased, or the time from when the block is erased to when programming of the erased block is completed.

For example, as the EPI time of a specific memory block increases, the changes in the threshold voltages of its memory cells may also increase. Once the EPI time exceeds a reference time, the data programmed in the block may be lost over time. In other words, as the EPI time of the memory block increases, the retention characteristics of the memory block may deteriorate.

To address the reduction in retention caused by an increased EPI time, a conventional controller manages the EPI time of a memory block separately. When the EPI time exceeds the reference time, the controller performs a "close" operation on the unused word lines of the memory block (i.e., those not yet programmed). By preventing programming after the EPI time surpasses the reference time, the reliability of the memory device 120 may increase.

In the conventional storage device, since the controller manages the EPI times of memory blocks, the controller's resources may become limited. Additionally, if the controller does not support EPI time management, the above operation may not function properly.

According to an embodiment of the present disclosure, the memory device 120 may manage the EPI times of memory blocks and provide the controller 110 with information (referred to as "EPI information INF EPI") about these EPI times. Based on the EPI information INF EPI, the controller 110 may perform the close operation on a memory block whose EPI time exceeds the reference time or may preferentially perform the program operation on the memory block whose EPI time exceeds the reference time. In other words, the controller 110 may either perform a close operation on memory blocks whose EPI times exceed the reference time or prioritize programming those memory blocks.

For example, the memory device 120 may include an EPI timer 121 and an EPI table 122. The EPI timer 121 may begin measuring the EPI time once the erase operation on a memory block is performed. For example, the memory device 120 may receive an erase command from the controller 110 and may perform the erase operation on a first memory block in response to the received erase command. The EPI timer 121 may begin measuring the EPI time of the first memory block once the erase operation on the first memory block is performed. Alternatively, the EPI timer 121 may perform the erase operation on the first memory block in response to the erase command being received from the controller 110. Alternatively, the EPI timer 121 may begin measuring the EPI time of the first memory block when a response indicating the completion of the erase operation is sent to the controller 110. The EPI time measured by the EPI timer 121 may be stored and managed in the EPI table 122.

When the EPI time of the first memory block exceeds the reference time, the memory device 120 may provide the controller 110 with information (i.e., EPI information) indicating that the EPI time of the first memory block exceeds the reference time.

In an embodiment, the EPI information INF EPI may be provided from the memory device 120 to the controller 110 through various methods. For example, the memory device 120 may receive a specific command (e.g., a status read command, a get feature command, or a vendor command) from the controller 110 and may provide the EPI information INF EPI to the controller 110 in response to the specific command. Alternatively, the memory device 120 may provide the EPI information INF_EPI to the controller 110 through a separate signal line.

The controller 110 may include an EPI manager 111. The EPI manager 111 may perform the program operation or the close operation on the first memory block in response to the EPI information INF EPI received from the memory device 120. For example, when user data to be stored in the first memory block exist, the EPI manager 111 may program the user data in the first memory block. Alternatively, when user data to be stored in the first memory block do not exist, the EPI manager 111 may perform the close operation on the first memory block. In an embodiment, the close operation may refer to an operation of performing a dummy data program operation on word lines of the first memory block, which are not yet programmed, or an operation of programming dummy data in memory cells of the first memory block, which are not yet programmed. In an embodiment, the close operation may be performed through an operation such as a dummy pattern write operation or a copyback write operation on the memory device 120.

As described above, according to an embodiment of the present disclosure, the memory device 120 may manage an EPI time of a memory block, and when the EPI time exceeds the reference time, the memory device 120 may provide the EPI information INF_EPI to the controller 110. The controller 110 may perform the program operation or the close operation on the memory block, based on the EPI information INF_EPI. Accordingly, even though the resource of the controller 110 is insufficient or the controller 110 does not provide the function of managing an EPI time, the reliability of the memory device 120 may be improved.

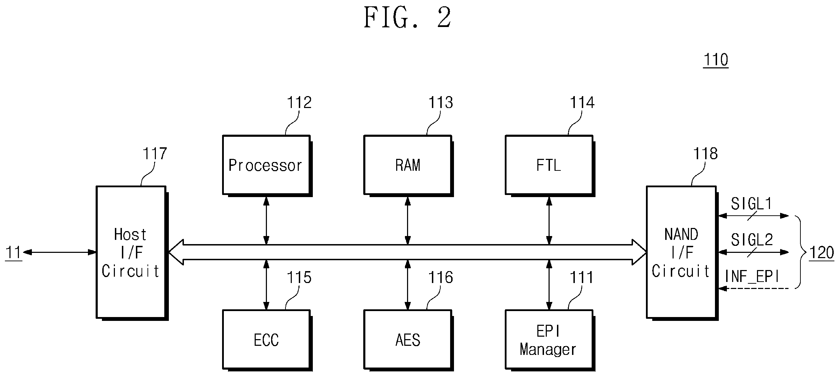

FIG. 2 is a block diagram illustrating a controller of FIG. 1. Referring to FIGS. 1 and 2, the controller 110 may include the EPI manager 111, a processor 112, a random access memory (RAM) 113, a flash translation layer (FTL) 114, an error correction code (ECC) engine 115, an advanced encryption standard (AES) engine 116, a host interface circuit 117, and a NAND interface circuit 118.

The EPI manager 111 may control the program operation or the close operation on the memory device 120 based on the EPI information INF_EPI received from the memory device 120. In an embodiment, the EPI manager 111 may not manage EPI times of memory blocks of the memory device 120.

The processor 112 may control all the operations of the controller 110. For example, the processor 112 may execute various applications on the controller 110. The RAM 113 may be configured to store various information necessary for the controller 110 to operate. In an embodiment, the RAM 113 may be used as a working memory, a cache memory, or a buffer memory of the controller 110.

The FTL 114 may perform maintenance operations for efficiently managing or using the memory device 120. In an embodiment, the maintenance operations may include an address mapping operation, a wear-leveling operation, a garbage collection operation, etc.

The address mapping operation of the FTL 114 may refer to an operation of translating a logical address received from the external host into a physical address to be used to actually store data in the memory device 120. In an embodiment, the FTL 114 may perform the address mapping operation by using L2P map data. The wear-leveling operation of the FTL 114 may refer to an operation of preventing excessive deterioration of a specific memory block among the memory blocks included in the memory device 120. For example, the FTL 114 may allocate the memory blocks included in the memory device 120 to be used uniformly, and thus, the excessive deterioration of the specific memory block may be prevented. In an embodiment, the wear-leveling operation of the FTL 114 may be implemented through firmware that balances erase counts of the memory blocks of the memory device 120. The garbage collection operation of the FTL 114 may refer to an operation of securing a memory block or a capacity available in the memory devices 120 by copying valid data of a source memory block to a target memory block and then switching the source memory block into a free block or erasing the source memory block. The FTL 114 may further perform various management operations such as a bad block management operation, in addition to the above operations. In an embodiment, some or all of the functions of the FTL 114 may be implemented through software, hardware, or a combination thereof.

The ECC engine 115 may perform an error detection and correction function on data read from the memory device 120. For example, the ECC engine 115 may generate parity bits for write data to be written in the memory device 120, and the parity bits thus generated may be stored in the memory device 120 together with the write data. When data are read from the memory device 120, the ECC engine 115 may correct an error of the read data by using the parity bits read from the memory device 120 together with the read data and may output the error-corrected read data.

The AES engine 116 may perform at least one of an encryption operation and a decryption operation on data input to the controller 110 by using a symmetric-key algorithm.

The host interface circuit 117 may communicate with the host 11 through a host interface. In an embodiment, the host interface may include at least one of various host interfaces such as a peripheral component interconnect express (PCI-express) interface, a PCI-express based nonvolatile memory express (NVMe) interface, a serial ATA (SATA) interface, a serial attached SCSI (SAS) interface, a universal flash storage (UFS) interface, and a compute express link (CXL) interface.

The NAND interface circuit 118 may communicate with the memory device 120. In an embodiment, the NAND interface circuit 118 may be implemented to comply with a protocol such as Toggle or an open NAND flash interface (ONFI). In an embodiment, the controller 110 may receive the EPI information INF_EPI from the memory device 120 through the NAND interface circuit 118.

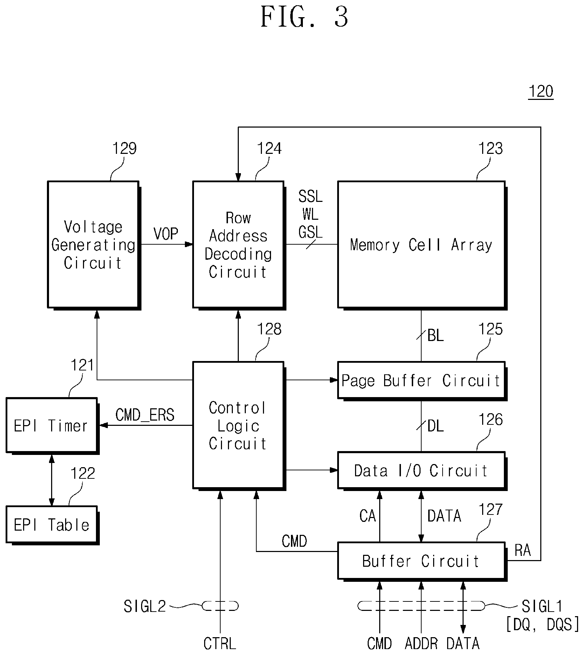

FIG. 3 is a block diagram illustrating a memory device of FIG. 1. Referring to FIGS. 1 and 3, the memory device 120 may include the EPI timer 121, the EPI table 122, a memory cell array 123, a row address decoding circuit 124, a page buffer circuit 125, a data input/output circuit 126, a buffer circuit 127, a control logic circuit 128, and a voltage generating circuit 129.

The EPI timer 121 may be configured to manage EPI times of a plurality of memory blocks included in the memory cell array 123. For example, the EPI timer 121 may begin measuring the EPI time of a first memory block once the memory device 120 completes the erase operation of the first memory block. Alternatively, the EPI timer 121 may start measuring the EPI time of the first memory block when the erase command for the first memory block is received. Alternatively, the EPI timer 121 may start measuring the EPI time of the first memory block when status information indicating the completion of the erase operation of the first memory block is transmitted to the controller 110. The EPI time managed or measured by the EPI timer 121 may be stored in the EPI table 122.

In an embodiment, the EPI table 122 may be stored in a separate storage circuit (e.g., a latch or a register).

The memory cell array 123 may include a plurality of memory blocks. Each of the plurality of memory blocks may include a plurality of cell strings. Each of the plurality of cell strings may include a plurality of cell transistors stacked in a direction perpendicular to a substrate. The plurality of cell transistors may be connected in series between bit lines BL and a common source line. The plurality of cell transistors may be connected to string selection lines SSL, word lines WL, and ground selection lines GSL.

The row address decoding circuit 124 may be connected to the memory cell array 123 through the string selection lines SSL, the word lines WL, and the ground selection lines GSL. The row address decoding circuit 124 may operate under control of the control logic circuit 128. For example, under control of the control logic circuit 128, the row address decoding circuit 124 may decode a row address RA received from the buffer circuit 127. Based on the decoding result, the row address decoding circuit 124 may control or drive the string selection lines SSL, the word lines WL, and the ground selection lines GSL, or it may control the voltages to be applied to the string selection lines SSL, the word lines WL, and the ground selection lines GSL.

The page buffer circuit 125 may be connected to the memory cell array 123 through the bit lines BL. The page buffer circuit 125 may be connected to the data input/output circuit 126 through a plurality of data lines DL. The page buffer circuit 125 may operate under control of the control logic circuit 128. For example, in the program operation of the memory device 120, under control of the control logic circuit 128, the page buffer circuit 125 may store data to be programmed in the memory cell array 123 and may control the bit lines BL based on the stored data. In the read operation of the memory device 120, the page buffer circuit 125 may sense voltages of the bit lines BL and may store the sensed voltages as read data.

The data input/output circuit 126 may be connected to the page buffer circuit 125 through the plurality of data lines DL. The data input/output circuit 126 may receive a column address CA from the buffer circuit 127. The data input/output circuit 126 may transmit the data read by the page buffer circuit 125 to the buffer circuit 127 based on the column address CA. The data input/output circuit 126 may transmit the data received from the buffer circuit 127 to the page buffer circuit 125, based on the column address CA.

The buffer circuit 127 may receive the command CMD and the address ADDR from the controller 110 through the first signal lines SIGL1 and may exchange the data "DATA" with the controller 110 through the first signal lines SIGL1. In an embodiment, the first signal lines SIGL1 may include data signal lines DQ and a data strobe signal line DQS.

The buffer circuit 127 may operate under control of the control logic circuit 128. For example, the control logic circuit 128 may exchange the control signals CTRL with the controller 110 through the second signal lines SIGL2. The control logic circuit 128 may control the buffer circuit 127 based on the control signals CTRL such that the buffer circuit 127 routes the command CMD, the address ADDR, and the data "DATA". Under control of the control logic circuit 128, the buffer circuit 127 may classify signals received through the first signal lines SIGL1 as the command CMD or the address ADDR. The buffer circuit 127 may transfer the command CMD to the control logic circuit 128. The buffer circuit 127 may transfer the row address RA of the address ADDR to the row address decoding circuit 124 and may transfer the column address CA of the address ADDR to the data input/output circuit 126. The buffer circuit 127 may exchange the data "DATA" with the data input/output circuit 126. In an embodiment, the second signal lines SIGL2 may include signal lines for transferring a chip enable signal (CE), a command latch enable signal (CLE), an address latch enable signal (ALE), a read enable signal (RE), a write enable signal (WE), a ready/busy signal (R/B), etc.

The control logic circuit 128 may decode the command CMD received from the buffer circuit 127 and may control the memory device 120 or various components of the memory device 120 based on a decoding result. For example, the control logic circuit 128 may receive an erase command CMD_ERS and may perform the erase operation on a relevant memory block in response to the received erase command CMD_ERS. In this case, the control logic circuit 128 may provide the erase command CMD_ERS to the EPI timer 121. The EPI timer 121 may start measuring an EPI time in response to the erase command CMD_ERS. Alternatively, the control logic circuit 128 may provide the EPI timer 121 with information indicating that the erase command CMD_ERS is received or information indicating that the erase operation corresponding to the erase command CMD_ERS is completed. The EPI timer 121 may start measuring the EPI time of the relevant memory block in response to the received information.

Under control of the control logic circuit 128, the voltage generating circuit 129 may generate various operating voltages VOP which are used in the memory device 120. In an embodiment, the operating voltages VOP may include various voltages such as program voltages, pass voltages, selection read voltages, non-selection read voltages, erase voltages, and verify voltages.

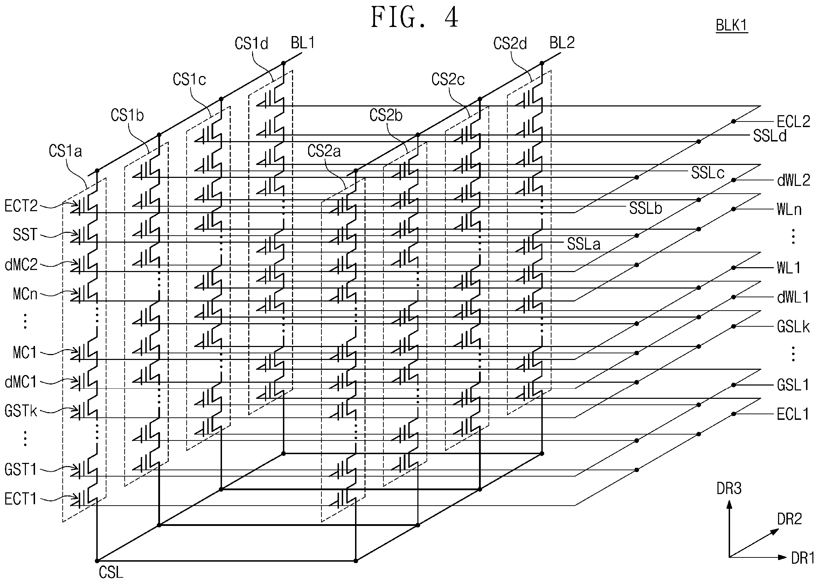

FIG. 4 is a circuit diagram illustrating a first memory block among a plurality of memory blocks included in a memory cell array of FIG. 3. A structure of a first memory block BLK1 will be described with reference to FIG. 4, but the present disclosure is not limited thereto. For example, the memory cell array 123 may include a plurality of memory blocks, each of which is similar in structure to the first memory block BLK1 of FIG. 4.

In an embodiment, the first memory block BLK1 to be described with reference to FIG. 4 may correspond to a physical erase unit of the memory device 120. However, the present disclosure is not limited thereto. For example, the memory device 120 may perform the erase operation in units of page, word line, sub-block, super block, or plane.

In an embodiment, the first memory block BLK1 to be described with reference to FIG. 4 is provided only as an example. The number of cell strings may increase or decrease, and the number of rows of cell strings and the number of columns of cell strings may increase or decrease depending on the number of cell strings. In addition, the number of cell transistors GST, MC, DMC, SST, and ECT of the first memory block BLK1 may increase or decrease, and the height of the first memory block BLK1 may increase or decrease depending on the number of cell transistors. In addition, the number of lines GSL, WL, DWL, and SSL connected to the cell transistors may increase or decrease depending on the number of cell transistors.

Referring to FIGS. 3 and 4, the first memory block BLK1 may include a plurality of cell strings CS1a, CS1b, CS1c, CS1d, CS2a, CS2b, CS2c, and CS2d. The plurality of cell strings CS1a to CS2d may be disposed along a first direction DR1 and a second direction DR2 to form rows and columns.

The plurality of cell strings CS1a to CS2d may be connected to bit lines BL1 and BL2. For example, each of the bit lines BL1 and BL2 may extend along the second direction DR2. The cell strings CS1a, CS1b, CS1c, and CS1d located at the same column, in other words, the first column from among the plurality of cell strings CS1a to CS2d may be connected to the first bit line BL1, and the cell strings CS2a, CS2b, CS2c, and CS2d located at the same column, in other words, the second column from among the plurality of cell strings CS1a to CS2d may be connected to the second bit line BL2.

The 1a-th cell string CS1a may include a plurality of cell transistors connected in series between the first bit line BL1 and a common source line CSL. The plurality of cell transistors of the 1a-th cell string CS1a located at the first column and first row may include a first erase control transistor ECT1, a plurality of ground selection transistors GST1 to GSTk, dummy memory cells dMC1 and dMC2, a plurality of memory cells MC1 to MCn, a string selection transistor SST, and a second erase control transistor ECT2. In an embodiment, each of the plurality of cell transistors may be implemented with a charge trap flash (CTF) memory cell.

The plurality of cell transistors of the 1a-th cell string CS1a may be connected in series and may be stacked in a third direction DR3 (or a height direction) which is a direction perpendicular to a plane defined by the first direction DR1 and the second direction DR2 or a substrate. For example, the plurality of memory cells MC1 to MCn may be connected in series and may be stacked in the third direction DR3 which is a direction perpendicular to the substrate. The string selection transistor SST may be provided between the plurality of memory cells MC1 to MCn and the first bit line BL1. The plurality of ground selection transistors GST1 to GSTk may be connected in series and may be stacked in the third direction DR3 (or a height direction) which is a direction perpendicular to the substrate. The plurality of ground selection transistors GST1 to GSTk connected in series may be provided between the plurality of memory cells MC1 to MCn connected in series and the common source line CSL.

In an embodiment, the first dummy memory cell dMC1 may be provided between the plurality of memory cells MC1 to MCn and the plurality of ground selection transistors GST1 to GSTk. In an embodiment, the second dummy memory cell dMC2 may be provided between the plurality of memory cells MC1 to MCn and the string selection transistor SST.

In an embodiment, the first erase control transistor ECT1 may be provided between the plurality of ground selection transistors GST1 to GSTk and the common source line CSL. The second erase control transistor ECT2 may be provided between the string selection transistor SST and the first bit line BL1. The first and second erase control transistors ECT1 and ECT2 may be used to charge the channel of the 1a-th cell string CS1a with an erase voltage or to erase the first memory block BLK1, based on a gate induced drain leakage (GIDL) phenomenon.

For convenience of description, the structure of the 1a-th cell string CS1a is described, but the present disclosure is not limited thereto. For example, each of the remaining cell strings CS1b to CS1d and CS2a to CS2d may be similar in structure to the 1a-th cell string CS1a.

The first erase control transistors ECT1 of the plurality of cell strings CS1a to CS2d may be connected in common to a first erase control line ECL1. The second erase control transistors ECT2 of the plurality of cell strings CS1a to CS2d may be connected in common to a second erase control line ECL2.

Memory cells located at the same height from the substrate from among the plurality of memory cells MC1 to MCn may be connected in common to the same word line, and memory cells located at another height from among the plurality of memory cells MC1 to MCn may be connected in common to another word line. For example, the first memory cells MC1 of the plurality of cell strings CS1a to CS2d may be located at the same height from the substrate and may be connected in common to a first word line WL1. The n-th memory cells MCn of the plurality of cell strings CS1a to CS2d may be located at the same height from the substrate and may be connected in common to an n-th word line WLn.

In an embodiment, the first dummy memory cells dMC1 of the plurality of cell strings CS1a to CS2d may be located at the same height from the substrate and may be connected in common to a first dummy word line dWL1. The second dummy memory cells dMC2 of the plurality of cell strings CS1a to CS2d may be located at the same height from the substrate and may be connected in common to a second dummy word line dWL2.

The string selection transistors SST of the plurality of cell strings CS1a to CS2d may be connected to a plurality of string selection lines SSLa to SSLd. For example, string selection transistors located at the same row may be connected to the same string selection line, and string selection transistors located at different rows may be connected to different string selection lines. In detail, the string selection transistors SST of the cell strings CS1a and CS2a located at the first row may be connected to an a-th string selection line SSLa; the string selection transistors SST of the cell strings CS1b and CS2b located at the second row may be connected to a b-th string selection line SSLb; the string selection transistors SST of the cell strings CS1c and CS2c located at the third row may be connected to a c-th string selection line SSLc; and, the string selection transistors SST of the cell strings CS1d and CS2d located at the fourth row may be connected to a d-th string selection line SSLd.

For convenience of description, the description was given as each of the plurality of cell strings CS1a to CS2d includes one string selection transistor SST, but the present disclosure is not limited thereto. Each of the plurality of cell strings CS1a to CS2d may include a plurality of string selection transistors, and string selection transistors located at the same row from among string selection transistors located at the same height from the substrate may be connected to the same string selection line; in this case, string selection transistors located at different rows may be connected to different string selection lines.

Ground selection transistors located at the same height from the substrate may be connected to the same ground selection line. For example, first ground selection transistors GST1 of the plurality of cell strings CS1a to CS2d may be located at the same height from the substrate and may be connected in common to a first ground selection line GSL1. k-th ground selection transistors GSTk of the plurality of cell strings CS1a to CS2d may be located at the same height from the substrate and may be connected in common to a k-th ground selection line GSLk.

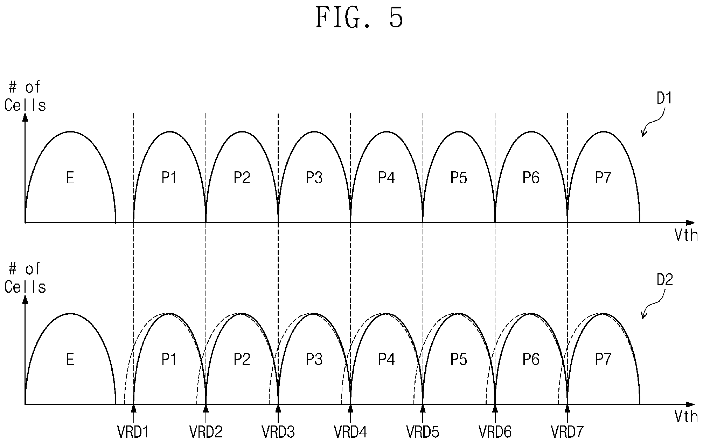

FIG. 5 is a diagram illustrating threshold voltage distributions of memory cells of a first memory block of FIG. 4. For convenience of description, it is assumed that each memory cell of the first memory block BLK1 is a triple level cell (TLC). However, the present disclosure is not limited thereto. For example, each memory cell may be implemented with a single level cell (SLC), a multi-level cell (MLC), a triple level cell (TLC), a quad-level cell (QLC), a penta-level cell (PLC), etc.

Referring to FIGS. 4 and 5, like that shown in a first distribution diagram D1, each memory cell MC of the first memory block BLK1 may be programmed to have one of an erase state "E" and a plurality of program states P1 to P7. The memory device 120 may read data stored in the memory cells MC by determining states of the memory cells MC by using a plurality of read voltages VRD1 to VRD7.

In an embodiment, when the program operation on the first memory block BLK1 is performed, the erase operation on the first memory block BLK1 is performed prior to the program operation. Afterwards, the program operations on the plurality of word lines WL1 to WLn of the first memory block BLK1 are sequentially performed. In this case, as a time interval (e.g., an erase left-alone time, an erase-program interval, or an EPI time) between the completion of the erase operation on the first memory block BLK1 and the programming of each word line or memory cell increases, the retention characteristics of the memory cells may deteriorate.

For example, after a given time or the reference time passes after the first memory block BLK1 is erased, the first memory block BLK1 may be programmed. Afterwards, when the given time passes, like that shown in a second distribution diagram D2, threshold voltages of the memory cells MC may decrease. In this case, the states of the memory cells MC may not be accurately determined using the plurality of read voltages VRD1 to VRD7.

In other words, when the EPI time of the first memory block BLK1 exceeds the reference time, a retention characteristic of the first memory block BLK1 may weaken. Accordingly, it is necessary to manage the EPI time of the first memory block BLK1 to ensure it remains within the reference time (i.e., to complete the programming of the first memory block BLK1 within the reference time from the moment it is erased).

According to an embodiment of the present disclosure, the memory device 120 may manage or store EPI times of a plurality of memory blocks. When the EPI time reaches the reference time, the memory device 120 may provide the EPI information INF_EPI to the controller 110, and the controller 110 may perform an operation (e.g., a program operation or a close operation) on a memory block based on the EPI information INF_EPI. Accordingly, even if the controller 110 has limited resources or does not support EPI time management, the controller 110 may use the EPI information INF EPI managed or stored by the memory device 120. This enhances the reliability of the memory device 120 and the storage device 100.

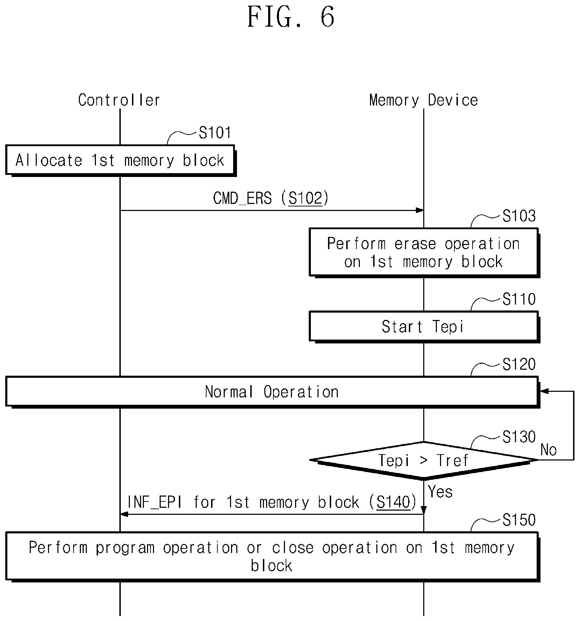

FIG. 6 is a flowchart illustrating an operation of a storage device of FIG. 1. Below, for convenience of description, an operation of the storage device 100 will be described based on the erase operation and the program operation on the first memory block BLK1. However, the present disclosure is not limited thereto.

Referring to FIGS. 1 and 6, in operation S101, the controller 110 may allocate the first memory block BLK1. For example, to store user data in the memory device 120, the controller 110 may allocate the first memory block BLK1.

In operation S102, the controller 110 may transmit the erase command CMD_ERS to the memory device 120. For example, the first memory block BLK1 may be a free block. In this case, to perform the program operation on the first memory block BLK1, the erase operation on the first memory block BLK1 should be first performed. The controller 110 may transmit the erase command CMD_ERS for erasing the first memory block BLK1 to the memory device 120.

In operation S103, the memory device 120 may perform the erase operation on the first memory block BLK1 in response to the erase command CMD_ERS.

In operation S110, the memory device 120 may start to measure or manage an EPI time Tepi of the first memory block BLK1 in which the erase operation is performed. For example, the memory device 120 may measure the EPI time Tepi of the first memory block BLK1 once the erase operation on the first memory block BLK1 is completed. Alternatively, the memory device 120 may measure the EPI time Tepi of the first memory block BLK1 in response to receiving the erase command CMD_ERS for the first memory block BLK1. Alternatively, the memory device 120 may measure the EPI time Tepi of the first memory block BLK1 in response to status information indicating the completion of the erase operation on the first memory block BLK1.

In other words, the memory device 120 may manage or measure the EPI time Tepi (or an erase left-alone time) of the first memory block BLK1.

In operation S120, the controller 110 and the memory device 120 may perform the normal operation. For example, the memory device 120 may perform the read operation, the program operation, or the erase operation under control of the controller 110.

In operation S130, the memory device 120 may determine whether the EPI time Tepi exceeds a reference time Tref. When the EPI time Tepi does not exceed the reference time Tref, the controller 110 and the memory device 120 may continue to perform operation S120.

When the EPI time Tepi exceeds the reference time Tref, in operation S140, the memory device 120 may transmit the EPI information INF EPI about the first memory block BLK1 to the controller 110. In an embodiment, the EPI information INF_EPI may include information indicating that the EPI time Tepi of the first memory block BLK1 exceeds the reference time Tref.

In an embodiment, the EPI information INF_EPI may be provided from the memory device 120 to the controller 110 through various methods. For example, the memory device 120 may transmit the EPI information INF_EPI to the controller 110 through a separate signal line. Alternatively, the memory device 120 may transmit the EPI information INF_EPI to the controller 110 in response to a specific command (e.g., a status read command, a get feature command, or a vendor command) received from the controller 110. However, the present disclosure is not limited thereto. For example, the memory device 120 may transmit the EPI information INF_EPI to the controller 110 through various methods.

In operation S150, the controller 110 may perform the program operation or the close operation on the first memory block BLK1, based on the EPI information INF_EPI. For example, when there is user data to be stored in the first memory block BLK1, the controller 110 may perform the program operation to store the user data in the first memory block BLK1. Alternatively, when there is no user data to be stored in the first memory block BLK1, the controller 110 may perform the close operation to close word lines of the first memory block BLK1, which are not used (or are not yet programmed). Operation S150 will be described in detail with reference to the following drawings.

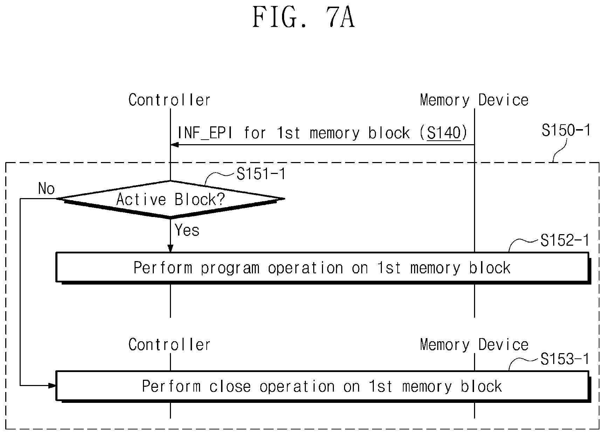

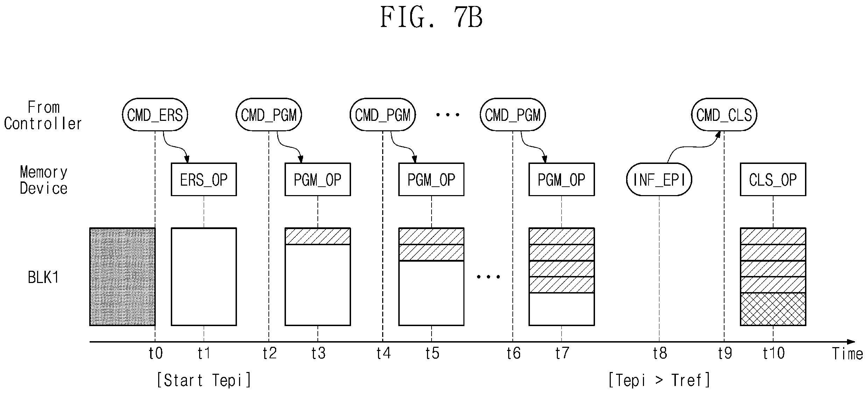

FIGS. 7A and 7B are diagrams for describing operation S150 of FIG. 6. Referring to FIGS. 1, 6, 7A, and 7B, in operation S140, the memory device 120 may transmit the EPI information INF_EPI to the controller 110.

In operation S151-1 of S150-1, the controller 110 may determine whether the first memory block BLK1 is an active block, based on the EPI information INF_EPI. For example, the controller 110 may determine whether user data or valid data needs to be stored in the first memory block BLK1. If such user data or valid data exists, the controller 110 may designate the first memory block BLK1 as an active block.

When the first memory block BLK1 is an active block, in operation S152-1, the controller 110 may perform the program operation on the first memory block BLK1. For example, the controller 110 may transmit a program command, an address, and the user data to the memory device 120. The memory device 120 may store the user data in the first memory block BLK1 in response to the received program command and address. In an embodiment, as the user data are stored in the first memory block BLK1, the program operation on the first memory block BLK1 may be completed (i.e., the program operation on all the memory cells of the first memory block BLK1 may be completed). Alternatively, the program operation on the first memory block BLK1 may not be completed. In this case, the controller 110 may perform operation S153-1.

When the first memory block BLK1 is not the active block, in operation S153-1, the controller 110 may perform the close operation on the first memory block BLK1. In an embodiment, the close operation may refer to an operation of performing a dummy data program operation on word lines, which are not yet programmed, from among a plurality of word lines of the first memory block BLK1. In other words, the close operation refers to performing a dummy data program operation on word lines that have not yet been programmed, from among the plurality of word lines in the first memory block BLK1. The controller 110 may transmit a close command CMD_CLS to close the first memory block BLK1 to the memory device 120. The memory device 120 may perform the close operation on the first memory block BLK1 in response to the close command CMD_CLS.

For example, as illustrated in FIG. 7B, at a 0-th point in time t0, the memory device 120 may receive the erase command CMD_ERS from the controller 110. At a first point in time t1, the memory device 120 may perform an erase operation ERS_OP on the first memory block BLK1 in response to the erase command CMD_ERS. In an embodiment, at the first point in time t1, the memory device 120 may start to measure the EPI time Tepi of the first memory block BLK1. At a second point in time t2, the memory device 120 may receive a program command CMD_PGM from the controller 110; at a third point in time t3, the memory device 120 may perform a program operation PGM_OP on the first memory block BLK1 in response to the program command CMD_PGM. At a fourth point in time t4, the memory device 120 may receive the program command CMD_PGM from the controller 110; at a fifth point in time t5, the memory device 120 may perform the program operation PGM_OP on the first memory block BLK1 in response to the program command CMD_PGM. At a sixth point in time t6, the memory device 120 may receive the program command CMD_PGM from the controller 110; at a seventh point in time t7, the memory device 120 may perform the program operation PGM_OP on the first memory block BLK1 in response to the program command CMD_PGM.

At an eighth point in time t8, the EPI time Tepi of the first memory block BLK1 may exceed the reference time Tref. In this case, the memory device 120 may transmit the EPI information INF_EPI about the first memory block BLK1 to the controller 110. The controller 110 may determine whether the first memory block BLK1 is an active block, based on the EPI information INF_EPI. When the first memory block BLK1 is not an active block, at a ninth point in time t9, the controller 110 may transmit the close command CMD _CLS to the memory device 120. At a tenth point in time 110, the memory device 120 may perform a close operation CLS_OP on the first memory block BLK1 in response to the close command CMD_CLS. In an embodiment, the close operation CLS_OP may be performed through the dummy pattern write operation or the copyback write operation on the first memory block BLK1.

As described above, the memory device 120 may manage the EPI time Tepi of the first memory block BLK1. If the EPI time Tepi exceeds the reference time Tref, the memory device 120 may transmit the EPI information INF EPI to the controller 110. Based on the EPI information INF_EPI, the controller 110 may determine whether the first memory block BLK1 is an active block. Depending on the result, the controller 110 may perform the program operation or the close operation on the first memory block BLK1. In this case, the close operation may be performed based on an explicit command from the controller 110.

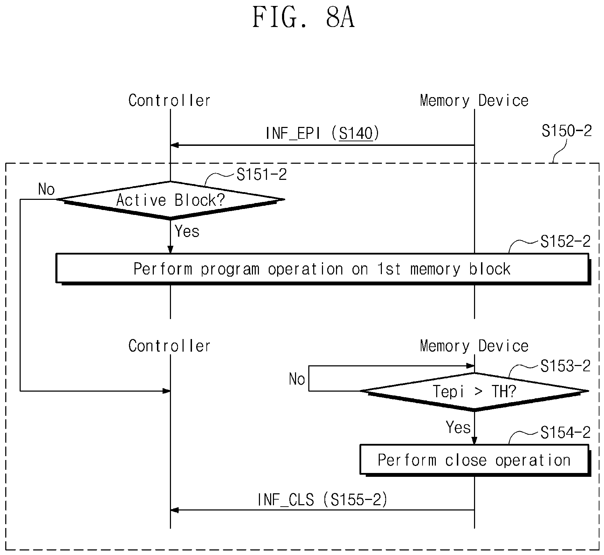

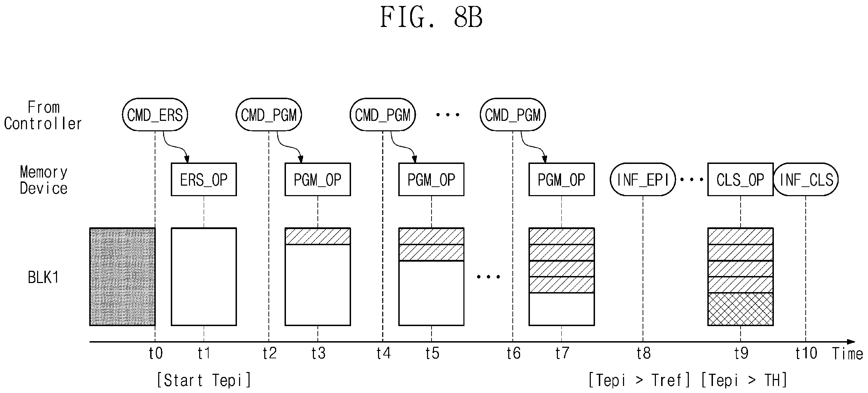

FIGS. 8A and 8B are diagrams for describing operation S150 of FIG. 6. Referring to FIGS. 1, 6, 8A, and 8B, in operation S140, the memory device 120 may transmit the EPI information INF_EPI to the controller 110.

In operation S151-2 of S150-2, the controller 110 may determine whether the first memory block BLK1 is an active block. When the first memory block BLK1 is an active block, in operation S152-2, the controller 110 may perform the program operation on the first memory block BLK1. Operation S151-2 and operation S152-2 are similar to operation S151-1 and operation S152-2 of FIG. 7A, and thus, additional description will be omitted to avoid redundancy.

When the first memory block BLK1 is not an active block, the controller 110 may not perform a separate operation (e.g., the program operation on the first memory block BLK1). In operation S153-2, the memory device 120 may determine whether the EPI time Tepi of the first memory block BLK1 exceeds a threshold time TH. In an embodiment, the threshold time TH may be longer than the reference time Tref.

When the EPI time Tepi does not exceed the threshold time TH, the memory device 120 may not perform a separate operation. Alternatively, the memory device 120 may operate under control of the controller 110.

When the EPI time Tepi exceeds the threshold time TH, in operation S154-2, the memory device 120 may perform the close operation on the first memory block BLK1. In an embodiment, when the first memory block BLK1 is not an active block, because the controller 110 does not perform a separate operation (e.g., the program operation on the first memory block BLK1), the EPI time of the first memory block BLK1 may continuously increase. In this case, the EPI time Tepi may exceed the threshold time TH. In other words, during a given time (e.g., a time of (TH - Tref)) from the moment the EPI information INF_EPI is provided to the controller 110, a command for the program operation associated with the first memory block BLK1 may not be received from the controller 110.

The memory device 120 may perform the close operation on the first memory block BLK1 without the explicit command from the controller 110. In an embodiment, the memory device 120 may perform the close operation by programming dummy data, random data, or a given data pattern on word lines of the first memory block BLK1, which are not used (i.e., are not yet programmed). Alternatively, through the copyback operation, the memory device 120 may perform the close operation by performing programming for word lines of the first memory block BLK1, which are not used (i.e., are not yet programmed).

In operation S155-2, the memory device 120 may transmit information (referred to as "close information") INF_CLS about the close operation to the controller 110. For example, as illustrated in FIG. 8B, during an interval from t0 to t7, the memory device 120 may receive the erase command CMD_ERS and the program command CMD_PGM from the controller 110 and may perform the erase operation ERS_OP and the program operation PGM_OP on the first memory block BLK1 in response to the received erase command CMD_ERS and the received program command CMD_PGM. In an embodiment, at the first point in time t1 when the erase operation ERS_OP is performed, the memory device 120 may start measuring the EPI time Tepi of the first memory block BLK1.

At an eighth point in time t8, the EPI time Tepi of the first memory block BLK1 may exceed the reference time Tref. In this case, the memory device 120 may transmit the EPI information INF_EPI to the controller 110. When the first memory block BLK1 is not an active block, the program operation on the first memory block BLK1 may not be performed, and at a ninth point in time t9, the EPI time Tepi may exceed the threshold time TH. In this case, the memory device 120 may perform the close operation on the first memory block BLK1 at the ninth point in time t9, and the memory device 120 may transmit close information INF_CLS to the controller 110 at a tenth point in time t10.

In an embodiment, the close information INF_CLS may include information indicating that the close operation of the first memory block BLK1 is performed. The controller 110 may recognize that the close operation on the first memory block BLK1 has been performed upon receiving the close information INF_CLS. In this case, the controller 110 may invalidate the unused word lines of the first memory block BLK1, where dummy data has been written. In an embodiment, the invalidated word lines may be managed by the FTL 114 of the controller 110 without writing any additional user data on them.

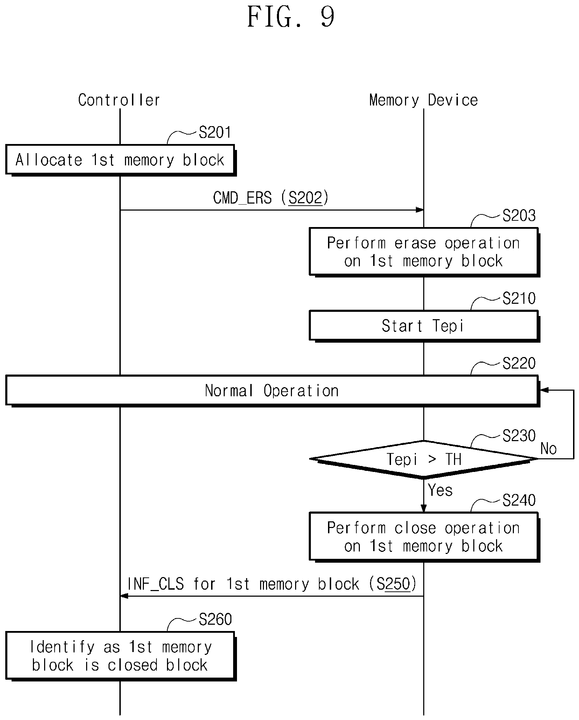

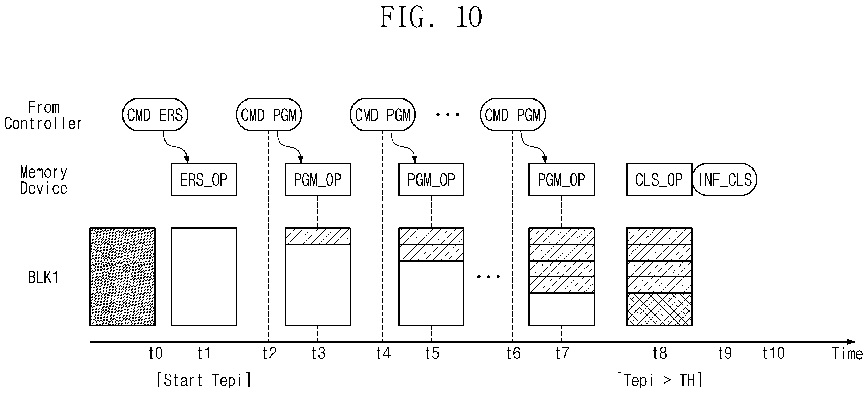

FIG. 9 is a flowchart illustrating an operation of a storage device of FIG. 1. FIG. 10 is a diagram for describing an operation according to the flowchart of FIG. 9. Referring to FIGS. 1, 9, and 10, the controller 110 and the memory device 120 may perform operation S201, operation S202, operation S203, operation S210, operation S220, and operation S230. Operation S201, operation S202, operation S203, operation S210, and operation S220 are similar to operation S101, operation S102, operation S103, operation S110, and operation S120 of FIG. 6, and thus, additional description will be omitted to avoid redundancy.

In operation S230, the memory device 120 may determine whether the EPI time Tepi exceeds the threshold time TH. When the EPI time Tepi does not exceed the threshold time TH, the memory device 120 and the controller 110 may continuously perform operation S220.

When the EPI time Tepi exceeds the threshold time TH, in operation S240, the memory device 120 may perform the close operation on the first memory block BLK1. The close operation in operation S240 is similar to operation S154-2 of FIG. 8A, and thus, additional description will be omitted to avoid redundancy.

In operation S250, the memory device 120 may transmit the close information INF _CLS about the first memory block BLK1 to the controller 110. In an embodiment, the close information INF_CLS may include information indicating that the close operation on the first memory block BLK1 is completed.

In an embodiment, the close information INF CLS may be provided from the memory device 120 to the controller 110 through various methods. For example, the memory device 120 may receive a specific command (e.g., a status read command, a get feature command, or a vendor command) from the controller 110 and may provide the close information INF _CLS to the controller 110 in response to the specific command. Alternatively, the memory device 120 may provide the close information INF_CLS to the controller 110 through a separate signal line.

In operation S260, the controller 110 may identify that the first memory block BLK1 is a closed block, based on the close information INF_CLS. For example, when the first memory block BLK1 is considered a closed block, it means that dummy data, random data, given data, or invalid data has been programmed on the word lines that do not contain user data, from among the word lines of the first memory block BLK1. As a result, the controller 110 may invalidate the word lines in the first memory block BLK1 that do not have user data programmed. In this case, no further program operations will be performed on the first memory block BLK1.

For example, as illustrated in FIG. 10, during an interval from t0 to t7, in response to the erase command CMD_ERS and the program command CMD_PGM received from the controller 110, the memory device 120 may perform the erase operation ERS_OP and the program operation PGM_OP on the first memory block BLK1. In an embodiment, at the first point in time t1 when the erase operation ERS_OP is performed, the memory device 120 may start measuring the EPI time Tepi of the first memory block BLK1.

At an eighth point in time t8, the EPI time Tepi may exceed the threshold time TH. In this case, the memory device 120 may perform the close operation on the first memory block BLK1 at the eighth point in time t8, and the memory device 120 may transmit the close information INF_CLS to the controller 110 at a ninth point in time t9.

As described above, the memory device 120 may manage the EPI time Tepi of the first memory block BLK1. In this case, when the EPI time Tepi exceeds the threshold time TH, the memory device 120 may perform the close operation CLS_OP on the first memory block BLK1 and may transmit the close information INF_CLS to the controller 110.

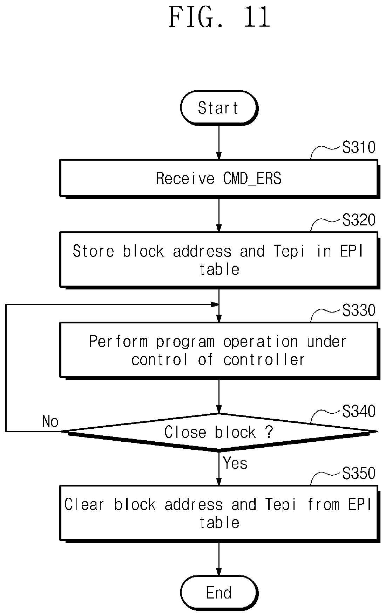

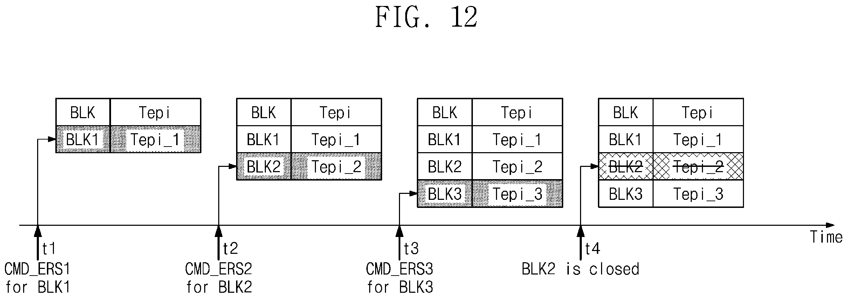

FIG. 11 is a flowchart illustrating an operation of a memory device of FIG. 1. FIG. 12 is a diagram for describing an operation according to the flowchart of FIG. 11. A method in which the memory device 120 manages EPI times of a plurality of memory blocks will be described with reference to FIGS. 11 and 12.

Referring to FIGS. 1, 11, and 12, in operation S310, the memory device 120 may receive the erase command CMD_ERS from the controller 110. The memory device 120 may perform the erase operation on a memory block in response to the erase command CMD_ERS.

In operation S320, the memory device 120 may store the EPI time Tepi and a block address in the EPI table 122. In an embodiment, the EPI time Tepi stored in the EPI table 122 may indicate a time at which the erase operation on the corresponding memory block is completed. Alternatively, the EPI time Tepi stored in the EPI table 122 may indicate information capable of identifying an erase left-alone time of the corresponding memory block. In other words, the EPI time Tepi stored in the EPI table 122 may provide information that identifies the erase left-alone time of the corresponding memory block.

In operation S330, the memory device 120 may perform the program operation under control of the controller 110.

In operation S340, the memory device 120 may determine whether a close block is present in memory blocks corresponding to block addresses stored in the EPI table 122. For example, when all word lines of a memory block are programmed under control of the controller 110, the memory block may be determined as being a close block. Alternatively, when the close operation on a memory block is performed, the memory block may be determined as being a close block. When a word line that has not yet been programmed is present in a memory block, the block may be determined as not being a closed block (i.e., it is considered an open block).

When a close block does not exist, the memory device 120 may perform operation S330. When a close block exists, in operation S350, the memory device 120 may clear a block address and an EPI time corresponding the close block from the EPI table 122.

For example, as illustrated in FIG. 12, at a first point in time t1, the memory device 120 may receive a first erase command CMD_ERS1 for the first memory block BLK1 from the controller 110 and may perform the erase operation on the first memory block BLK1 in response to the first erase command CMD_ERS1. In this case, the memory device 120 may store information (e.g., a block address or a block identifier) about the first memory block BLK1 and a first EPI time Tepi_1 in the EPI table 122.

At a second point in time t2, the memory device 120 may receive a second erase command CMD_ERS2 for a second memory block BLK2 from the controller 110 and may perform the erase operation on the second memory block BLK2 in response to the second erase command CMD_ERS2. In this case, the memory device 120 may store information (e.g., a block address or a block identifier) about the second memory block BLK2 and a second EPI time Tepi_2 in the EPI table 122.

At a third point in time t3, the memory device 120 may receive a third erase command CMD_ERS3 for a third memory block BLK3 from the controller 110 and may perform the erase operation on the third memory block BLK3 in response to the third erase command CMD_ERS3. In this case, the memory device 120 may store information (e.g., a block address or a block identifier) about the third memory block BLK3 and a third EPI time Tepi_3 in the EPI table 122.

In an embodiment, each of the first to third EPI times Tepi_1, Tepi_2, and Tepi_3 may include information about when the erase operation for each of the first to third memory blocks BLK1 to BLK3 was performed or completed (e.g., corresponding to the first to third time points t1, t2, and t3). In this case, the memory device 120 may calculate an erase left-alone time (i.e., the actual EPI time) of each memory block based on the EPI times stored in the EPI table 122 and the current time.

At a fourth point in time t4, the second memory block BLK2 may be closed. For example, at the fourth point in time t4, the program operation on the last word line of the second memory block BLK2 may be completed under control of the controller 110. Alternatively, at the fourth point in time t4, the close operation of the second memory block BLK2 may be performed.

In this case, the memory device 120 may delete or clear the information and the second EPI time Tepi_2 associated with the second memory block BLK2 from the EPI table 122. In an embodiment, the second EPI time Tepi_2 of the second memory block BLK2 may not be separately managed by the memory device 120.

In an embodiment, when the erase operation on the second memory block BLK2 is performed again, the memory device 120 may again store the block address of the second memory block BLK2 and a second (e.g., new) EPI time, based on the time when the erase operation on the second memory block BLK2 is performed again, in the EPI table 122.

As described above, because the memory device 120 manages only the EPI times of memory blocks that are currently open, it can manage EPI times using fewer resources.

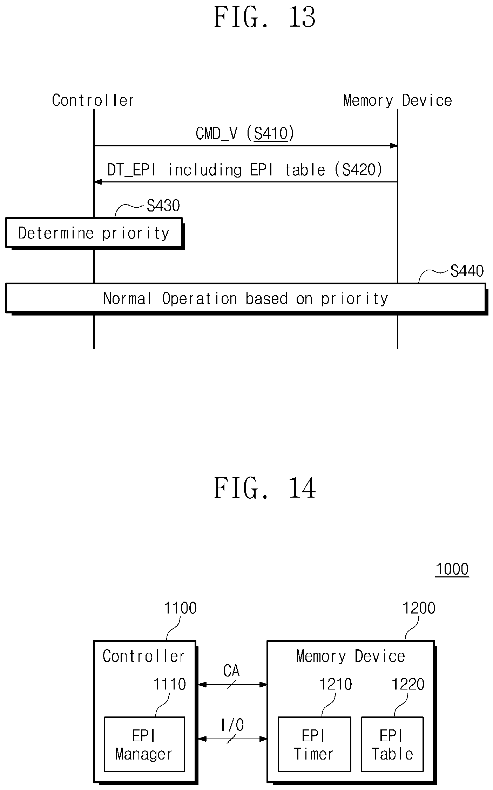

FIG. 13 is a flowchart illustrating an operation of a storage device of FIG. 1. In the above embodiments, when the EPI time Tepi exceeds the reference time Tref, the memory device 120 may transmit the EPI information INF_EPI to the controller 110. However, the present disclosure is not limited thereto.

For example, in operation S410, the controller 110 may transmit a specific command CMD_V to the memory device 120. In an embodiment, the specific command CMD_V may be a command for obtaining EPI data DT_EPI from the EPI table 122 which is managed in the memory device 120. The specific command CMD_V may be a status read command, a get feature command, or a vendor command.

In operation S420, the memory device 120 may transmit the EPI data DT_EPI including the EPI table 122 to the controller 110 in response to the specific command CMD_V. For example, the EPI data DT_EPI may include information about a block address and an EPI time included in the EPI table 122.

In operation S430, the controller 110 may determine a priority of a memory block, based on the EPI data DT_EPI. In operation S440, the controller 110 may perform the normal operation (e.g., a read operation or a program operation) on the memory device 120, based on the priority.

For example, the EPI data DT_EPI may include information about a block address and an EPI time included in the EPI table 122. In this case, the controller 110 may first perform the program operation on a memory block corresponding to the longest EPI time (or the earliest erase completion time). For example, when the first EPI time Tepi_1 of the first memory block BLK1 is longer than the second EPI time Tepi_2 of the second memory block BLK2, the controller 110 may control the memory device 120 such that the program operation on the first memory block BLK1 is first performed. In this case, because the program operation on the first memory block BLK1 corresponding to a relatively long EPI time is first performed, the reduction of reliability of the memory block due to an increase in the EPI time may be prevented. In other words, by prioritizing the program operation on the first memory block BLK1, which has a relatively long EPI time, the reduction in the memory block's reliability due to the extended EPI time can be prevented.

As described above, according to an embodiment of the present disclosure, the memory device 120 may manage EPI times of memory blocks. When an EPI time exceeds the reference time, the memory device 120 may provide the EPI information INF_EPI to the controller 110. The controller 110 may perform the program operation or the close operation on the memory block, based on the EPI information INF_EPI. Accordingly, even if the controller 110 has limited resources or lacks EPI-related functions, the management of EPI times by the memory device 120 ensures improved reliability for both the memory device 120 and the storage device 100.

The embodiment in which when an EPI time of a memory block exceeds the reference time, the close operation on the memory block is performed as described above, but the present disclosure is not limited thereto. For example, the controller 110 may vary an operation mode (e.g., an SLC mode, an MLC mode, or an TLC mode) corresponding to a memory block based on the EPI information INF_EPI. In detail, for example, when the EPI time Tepi of the first memory block BLK1 exceeds the reference time Tref, the controller 110 may change the operation mode of the first memory block BLK1 from the TLC mode to the SLC mode in response to the EPI information INF_EPI. In this case, when unused (or available) word lines of the first memory block BLK1 are programmed in the SLC mode, a retention characteristic may be maintained.

FIG. 14 is a block diagram illustrating a storage device according to an embodiment of the present disclosure. For convenience of description, additional descriptions for components described above will be omitted to avoid redundancy. Referring to FIG. 14, a storage device 1000 may include a controller 1100 and a memory device 1200. The controller 1100 may store data in the memory device 1200 or may read data stored in the memory device 1200.

The controller 1100 may include an EPI manager 1110. The memory device 1200 may include an EPI timer 1210 and an EPI table 1220. Functions or operations of the EPI manager 1110, the EPI timer 1210, and the EPI table 1220 may be similar to those described above. For example, the EPI timer 1210 of the memory device 1200 may manage the EPI time Tepi of each memory block and may store the EPI time Tepi of each memory block in the EPI table 1220. When an EPI time exceeds the reference time, the memory device 1200 may transmit the EPI information INF_EPI or an EPI packet PCK_EPI to the controller 1100. In an embodiment, the EPI information INF_EPI or the EPI packet PCK_EPI may include information about an EPI time managed by the memory device 1200 or information about a block address managed by the memory device 1200. The EPI manager 1110 of the controller 1100 may perform the program operation or the close operation on to the memory block, based on the EPI information INF_EPI or the EPI packet PCK_EPI. Functions or operations of the controller 1100 and the memory device 1200 are described above, and thus, additional description will be omitted to avoid redundancy.

In an embodiment, the controller 1100 and the memory device 1200 may communicate with each based on a given interface. The given interface may be a separate command/address (SCA) NAND interface. The SCA NAND interface may indicate a protocol for an interface in which a command/address (CA) channel and a data input/output channel (an I/O channel or a DQ channel) are separated from each other.

For example, in the embodiments described with reference to FIGS. 1 to 3, the controller 110 and the memory device 120 communicate with each other through the first and second signal lines SIGL1 and SIGL2. In this case, the first signal lines SIGL1 include signal lines (e.g., DQ/DQS) for transmitting/receiving a command, an address, and data, and the second signal lines SIGL2 include signal lines (e.g., CLE, ALE, RE, and WE) for transmitting/receiving control signals for classifying the signals transmitted/received through the first signal lines SIGL1. In other words, in the embodiment described with reference to FIGS. 1 to 3, the command, the address, and the data are transmitted/received through the first signal lines SIGL1.

In contrast, in the embodiment of FIG. 14, the controller 1100 may transmit the command and the address to the memory device 1200 through the command/address signal lines CA and may transmit/receive the data to/from through the input/output lines I/O. In this case, because a channel for the command/address CA and a channel for data input/output (I/O) are physically separated, the efficiency of controlling the memory device 1200 may be improved.

In an embodiment, the memory device 1200 may receive a status command CMD_S from the controller 1100 through the command/address signal lines CA and may transmit the EPI information INF EPI to the controller 1100 through the command/address signal lines CA in response to the received status command CMD_S. In this case, while the controller 1100 and the memory device 1200 transmit/receive data through the data input/output signal lines I/O, the memory device 1200 may transmit the EPI information INF_EPI to the controller 1100. As a result, since no additional time is required to transmit/receive the EPI information INF_EPI, the performance and reliability of the storage device 1000 may be improved.

Below, for convenience of description, the terms "command/address signal lines CA", "CA channels", and "CA signal lines" are interchangeably used, and the terms "input/output signal lines I/O", "data signal lines", "DQ channels", and "input/output channels" are interchangeably used. However, the present disclosure is not limited thereto. Each term should be understood depending on technical features of embodiments of the present disclosure.

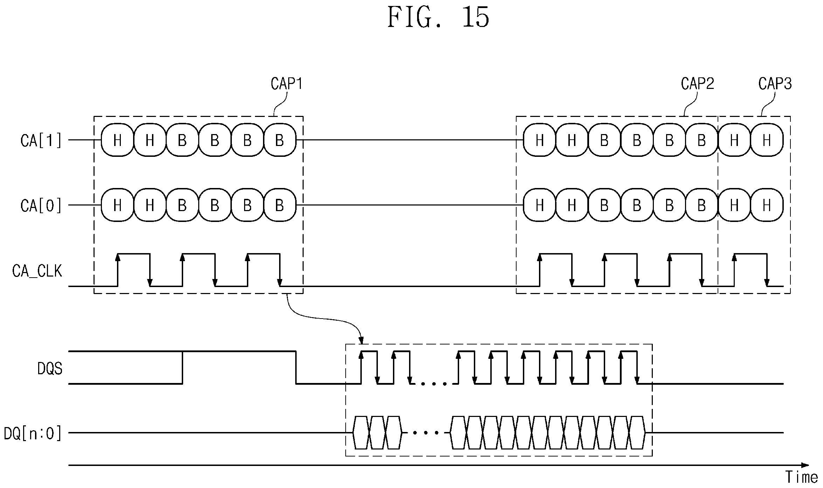

FIG. 15 is a timing diagram for describing an operation of a storage device of FIG. 14. For convenience of description and for brevity of drawing, some of signal lines between the controller 1100 and the memory device 1200 are illustrated, but the present disclosure is not limited thereto.

Referring to FIGS. 14 and 15, the controller 1100 may transmit a first command/address packet CAP1 to the memory device 1200 through 0-th and first command/address signals CA[0] and CA[1]. For example, the controller 1100 may transmit the first command/address packet CAP1 to the memory device 1200 through the 0-th and first command/address signals CA[0] and CA[1], which are center-aligned with the rising edge and the falling edge of a command/address clock CA_CLK. In this case, the first and second bits of each of the 0-th and first command/address signals CA[0] and CA[1] may indicate header bits "H", and the remaining bits thereof may indicate body bits "B".

When the first command/address packet CAP1 indicates the program operation, the controller 1100 may transmit data to the memory device 1200 through data signals DQ[n:0] and a data strobe signal DQS included in the input/output signals I/O.

While the controller 1100 transmits data to the memory device 1200 through the data signals DQ[n:0] and the data strobe signal DQS included in the input/output signals I/O, the controller 1100 may transmit a second command/address packet CAP2 and a third command/address packet CAP3 to the memory device 1200 through the 0-th and first command/address signals CA[0] and CA[1].

As described above, because a command/address channel CA and the data input/output channel I/O are physically separated, the controller 1100 and the memory device 1200 may perform the transmission/reception of a command/address and the transmission/reception of data in parallel or simultaneously.

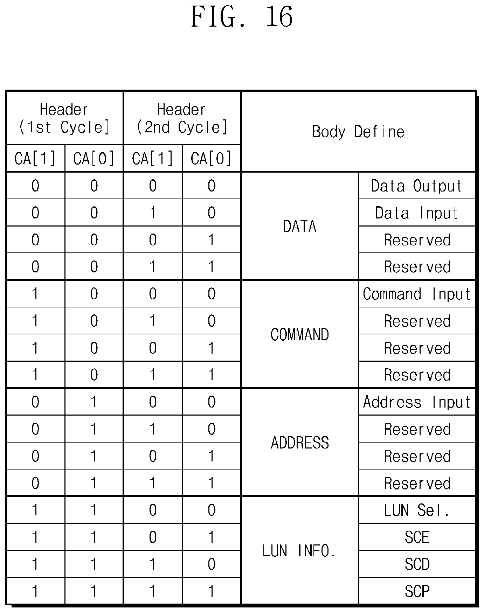

FIG. 16 is a diagram for describing a header of a command/address packet of FIG. 15. Some of examples of a header of a command/address packet will be described with reference to FIG. 16, but the present disclosure is not limited thereto.

Referring to FIGS. 14 to 16, the first and second bits of each of the 0-th and first command/address signals CA[0] and CA[1] indicate the header bits "H". A format or a type of the command/address packet to be currently transmitted/received may be determined by the header bits "H".

Below, for convenience of description, a header is expressed in the form of [ABCD]. In this case, "A" and "C" indicate bit values of the first and 0-th command/address signals CA[1] and CA[0] at the first rising edge of the command/address clock CA_CLK, respectively; "B" and "D" indicate bit values of the first and 0-th command/address signals CA[1] and CA[0] at the first falling edge of the command/address clock CA_CLK.

For example, when the header bits "H" are "0000", the body bits "B" of the corresponding command/address packet indicate a data output (i.e., data provided from the memory device 1200 to the controller 1100). When the header bits "H" are "0010", the body bits "B" of the corresponding command/address packet indicate a data input (i.e., data provided from the controller 1100 to the memory device 1200).

When the header bits "H" are "1000", the body bits "B" of the corresponding command/address packet indicate a command input (i.e., a command provided from the controller 1100 to the memory device 1200).

When the header bits "H" are "0100", the body bits "B" of the corresponding command/address packet indicate an address input (i.e., an address from the controller 1100 to the memory device 1200).

When the header bits "H" are "1100", the body bits "B" of the corresponding command/address packet indicate LUN select information; when the header bits "H" are "1101", the body bits "B" of the corresponding command/address packet indicate selected chip data enable (SCE) information; when the header bits "H" are "1110", the body bits "B" of the corresponding command/address packet indicate selected chip disable (SCD) information; and, when the header bits "H" are "1111", the body bits "B" of the corresponding command/address packet indicate selected chip data pause (SCP) information.

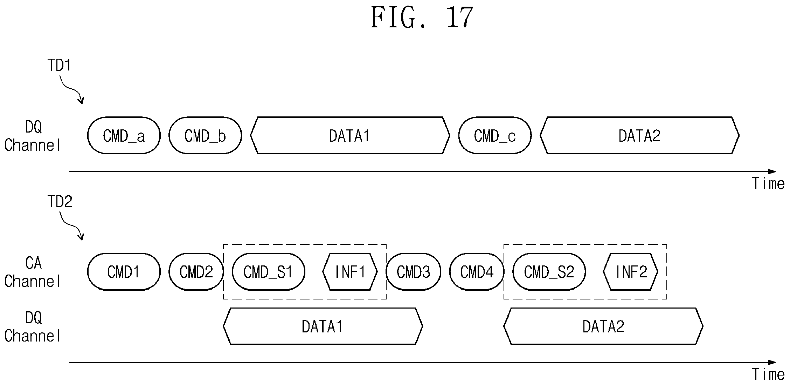

FIG. 17 is a diagram for describing a characteristic of an SCA NAND interface of a storage device of FIG. 14. Referring to FIGS. 14 and 17, a first timing diagram TD1 shows a signal transmission/reception method according to a conventional toggle interface (e.g., a method of transmitting a command and data for the program operation). A second timing diagram TD2 shows a signal transmission/reception method according to the SCA NAND interface (e.g., a method of transmitting a command and data for the program operation).

As shown in the first timing diagram TD1, according to the conventional toggle interface, a-th and b-th commands CMD_a and CMD_b, first data DATA1, a c-th command CMD_c, and second data DATA2 are sequentially transmitted to a memory device through a DQ channel.

In contrast, as shown in the second timing diagram TD2, according to the SCA NAND interface, first and second commands CMD1 and CMD2 are transmitted to the memory device 1200 through the CA channel, and the first data DATA1 are transmitted to the memory device 1200 through the DQ channel. In this case, because the CA channel and the DQ channel are physically separated from each other, while the first data DATA1 are transmitted to the memory device 1200, the controller 1100 may transmit a first status command CMD_S1 to the memory device 1200 through the CA channel and may receive first information INF1 from the memory device 1200 through the CA channel.

Afterwards, third and fourth commands CMD3 and CMD4 are transmitted to the memory device 1200 through the CA channel, and the second data DATA2 are transmitted to the memory device 1200 through the DQ channel. Likewise, while the second data DATA2 are transmitted to the memory device 1200, the controller 1100 may transmit a second status command CMD_S2 to the memory device 1200 through the CA channel and may receive second information INF2 from the memory device 1200 through the CA channel.

In other words, according to the SCA NAND interface, while data are transmitted/received through the DQ channel, various information may be transmitted/received through the CA channel. Accordingly, because a separate time is not required to obtain various information about the memory device 1200, the performance of the storage device 1000 may be improved. In an embodiment, the first and second information INF1 and INF2 described with reference to FIG. 17 may include the EPI information INF_EPI or the close information INF_CLS according to an embodiment of the present disclosure.

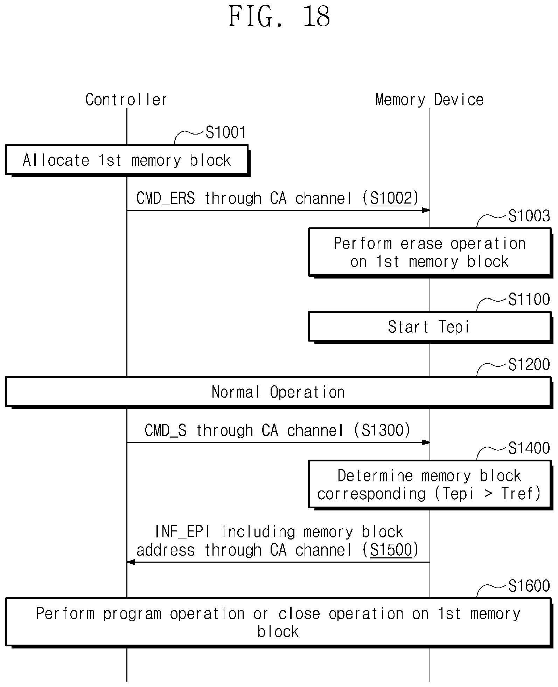

FIG. 18 is a flowchart illustrating an operation of a storage device of FIG. 14. Referring to FIGS. 14 and 18, the controller 1100 and the memory device 1200 may perform operation S1001, operation S1002, operation S1003, operation S1100, and operation S1200.

Operation S1001, operation S1002, operation S1003, operation S 1100, and operation S1200 are similar to operation S101, operation S102, operation S103, operation S110, and operation S120 of FIG. 6 except that the SCA NAND interface is used, and thus, additional description will be omitted to avoid redundancy.

In operation S1300, the controller 1100 may transmit the status command CMD_S to the memory device 120. For example, the controller 1100 may transmit the status command CMD_S to the memory device 1200 through the CA channel, based on the method described with reference to FIGS. 16 and 17.

In operation S1400, the memory device 1200 may identify memory blocks where the EPI time Tepi exceeds the reference time Tref. For example, this determination can be made based on the EPI table 1220, which stores the EPI times of the memory blocks.

In operation S1500, the memory device 1200 may transmit the EPI information INF_EPI including a memory block address to the controller 1100 through the CA channel. In an embodiment, the EPI information INF_EPI may be provided from the memory device 1200 to the controller 1100 using the header bits "H" of "0000," which indicate data output, as described with reference to FIG. 16. In other words, the EPI information INF EPI may be provided from the memory device 1200 to the controller 1100 in the form of a packet. In an embodiment, the EPI information INF EPI may include block addresses or block identifiers of memory blocks whose EPI times Tepi exceed the reference time Tref.

In operation S1600, the controller 1100 may perform the program operation or the close operation corresponding to the received memory block address. Operation S1600 is similar to operation S150 of FIG. 6, and thus, additional description will be omitted to avoid redundancy.

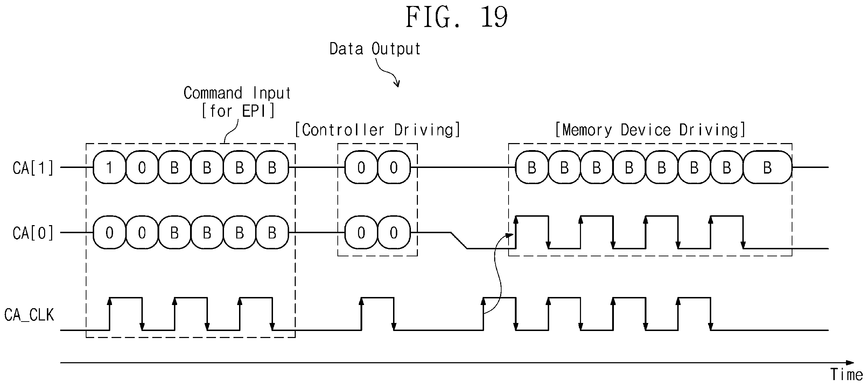

FIG. 19 is a timing diagrams for describing operation S1300 and operation S1500 of FIG. 18. Referring to FIGS. 14, 18, and 19, the controller 1100 may transmit the status command CMD_S for obtaining the EPI information INF_EPI to the memory device 1200 through the CA channel (e.g., the 0-th and first command/address signals CA[0] and CA[1]). In this case, the header bits "H" corresponding to the status command CMD_S may correspond to "1000", and the body bits "B" corresponding to the status command CMD_S may include information for obtaining the EPI information INF_EPI.

Afterwards, the controller 1100 may transmit the header bits "H" of "0000" indicating the data output to the memory device 1200 through the CA channel (e.g., the 0-th and first command/address signals CA[0] and CA[1]). In other words, the header bits "H" of "0000" may be driven by the controller 1100.

The memory device 1200 may output the body bits "B" including the EPI information INF_EPI in response to the header bits "H" of "0000". For example, the memory device 1200 may allow the 0-th command/address signal CA[0] to toggle, based on the command/address clock CA_CLK. The memory device 1200 may output the body bits "B," which include the EPI information INF_EPI aligned with the rising edge and the falling edge of the 0-th command/address signal CA[0]. The controller 1100 may receive the body bits "B" including the EPI information INF_EPI through the CA channel (e.g., the 0-th and first command/address signals CA[0] and CA[1]).

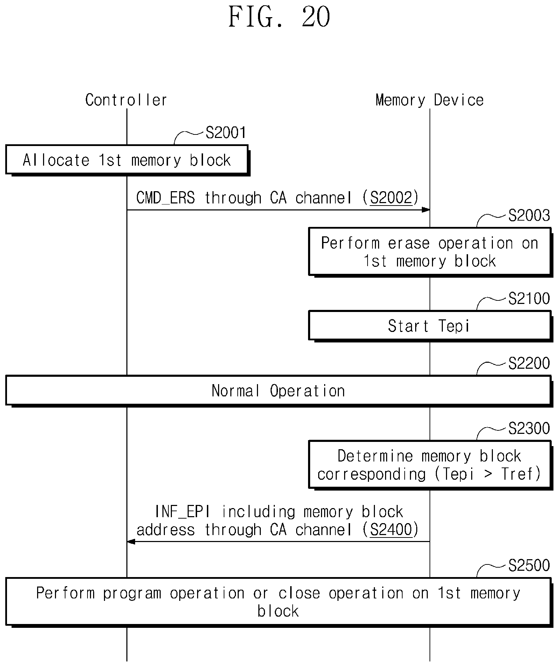

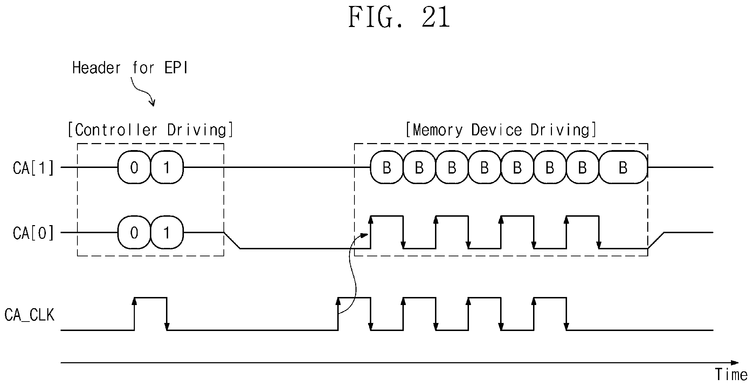

FIG. 20 is a flowchart illustrating an operation of a storage device of FIG. 14. FIG. 21 is a diagram for describing operation S2400 of FIG. 20. Referring to FIGS. 14, 20, and 21, the controller 1100 and the memory device 1200 may perform operation S2001, operation S2002, operation S2003, operation S2100, and operation 2200. Operation S2001, operation S2002, operation S2003, operation S2100, and operation 2200 are similar to operation S1001, operation S1002, operation S1003, operation S1100, and operation S1200 of FIG. 18, and thus, additional description will be omitted to avoid redundancy.

In operation S2300, the memory device 1200 may identify memory blocks where the EPI time Tepi exceeds the reference time Tref. For example, this identification can be made based on the EPI table 1220, which tracks the EPI times of the memory blocks.

In operation S2400, the memory device 1200 may transmit the EPI information INF_EPI including a memory block address to the controller 1100 through the CA channel. In the embodiment described with reference to FIGS. 18 and 19, the memory device 1200 may provide the EPI information INF EPI to the controller 1100 in response to the status command CMD _S received from the controller 1100. In contrast, in the embodiment of FIG. 20, the memory device 1200 may provide the EPI information INF_EPI to the controller 1100 based on the CA signal corresponding to the data output, without a separate command.

For example, as illustrated in FIG. 21, the controller 1100 may transmit the header bits "H" of "0011" to the memory device 1200. In this case, the header bits "H" of "0011" may correspond to reserved bits among header bits associated with data. In an embodiment, the header bits "H" of "0011" may be designated as header bits for receiving the EPI information INF_EPI. The header bits "H" of "0011" are provided as an example, and the present disclosure is not limited thereto.

The memory device 1200 may output the body bits "B" including the EPI information INF_EPI in response to the header bits "H" of "0011". For example, the memory device 1200 may allow the 0-th command/address signal CA[0] to toggle, based on the command/address clock CA_CLK. The memory device 1200 may output the body bits "B," which include the EPI information INF_EPI, synchronized with the 0-th command/address signal CA[0], or edge-aligned with the rising edge and the falling edge of the 0-th command/address signal CA[0]. The controller 1100 may receive the body bits "B" including the EPI information INF_EPI through the CA channel (e.g., the 0-th and first command/address signals CA[0] and CA[1]).

In an embodiment, an operation in which the memory device 1200 transmit the EPI information INF _EPI to the controller 1100 may be performed while the memory device 1200 and the controller 1100 transmit/receive data through the input/output channel.

In operation S2500, the controller 1100 may perform the program operation or the close operation on the memory block based on the EPI information INF_EPI. Operation S2500 is similar to operation S150 of FIG. 6, and thus, additional description will be omitted to avoid redundancy.

As described above, according to an embodiment of the present disclosure, a memory device may manage EPI times of memory blocks. When an EPI time exceeds the reference time, the memory device may provide EPI information to a controller, and the controller may perform the program operation or the close operation on the corresponding memory block based on the EPI information. Alternatively, the controller may determine a priority of each memory block based on the EPI information and may perform the program operation or the close operation on each memory block based on the priority.

In an embodiment, the controller and the memory device may communicate with each other based on the SCA NAND interface, and the memory device may provide the EPI information to the controller through the CA channel.

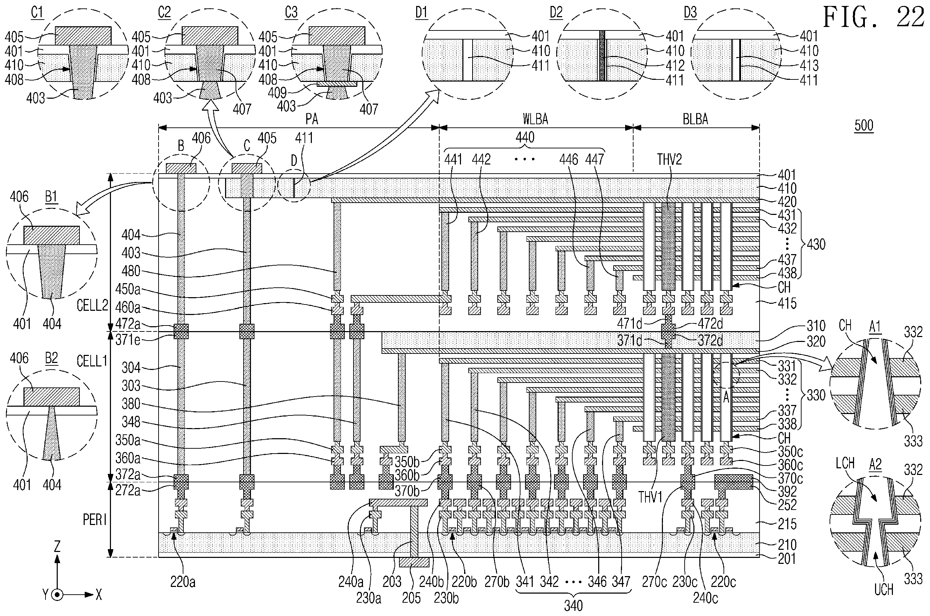

FIG. 22 is a view for describing a memory device 500 according to an embodiment of the present disclosure.

Referring to FIG. 22, the memory device 500 may have a chip-to-chip (C2C) structure. In the C2C structure, after fabricating at least one upper chip including a cell region CELL and at least one lower chip including a peripheral circuit region PERI, the upper and lower chips may be bonded together using a bonding method. As an example, the bonding method may involve electrically or physically connecting a bonding metal pattern in the topmost metal layer of the upper chip to a bonding metal pattern in the topmost metal layer of the lower chip. For example, when the bonding metal patterns are formed of copper (Cu), the bonding method may be referred to as a "Cu-Cu bonding method". As another example, the bonding metal patterns may also be formed of aluminum (Al) or tungsten (W).

The memory device 500 may include at least one upper chip including a cell region. For example, as illustrated in FIG. 22, the memory device 500 may be implemented to include two upper chips. However, this is illustrative, and the number of upper chips is not limited thereto. In the case in which the memory device 500 is implemented to include two upper chips, the memory device 500 may be manufactured by separately manufacturing a first upper chip including a first cell region CELL1, a second upper chip including a second cell region CELL2, and a lower chip including a peripheral circuit region PERI and thereafter connecting the first upper chip, the second upper chip, and the lower chip by a bonding method. The first upper chip may be turned over and connected to the lower chip by the bonding method, and the second upper chip may also be turned over and connected to the first upper chip by the bonding method. In the following description, upper portions and lower portions of the first and second upper chips are defined before the first upper chip and the second upper chip are turned over. Specifically, in FIG. 22, an upper portion of the lower chip refers to the area defined along a +Z-axis direction, and the upper portions of the first and second upper chips refer to the area defined along a -Z-axis direction. However, this is illustrative, and only one of the first upper chip and the second upper chip may be turned over and connected by the bonding method.

Each of the peripheral circuit region PERI and the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b, and 220c formed on the first substrate 210. An interlayer insulating layer 215 including one or more insulating layers may be provided on the plurality of circuit elements 220a, 220b, and 220c, and a plurality of metal lines connecting the plurality of circuit elements 220a, 220b, and 220c may be provided in the interlayer insulating layer 215. For example, the plurality of metal lines may include first metal lines 230a, 230b, and 230c connected with the plurality of circuit elements 220a, 220b, and 220c, respectively, and second metal lines 240a, 240b, and 240c formed on the first metal lines 230a, 230b, and 230c. The plurality of metal lines may be formed of at least one of various conductive materials. For example, the first metal lines 230a, 230b, and 230c may be formed of tungsten having a relatively high electrical resistivity, and the second metal lines 240a, 240b, and 240c may be formed of copper having a relatively low electrical resistivity.

In this specification, only the first metal lines 230a, 230b, and 230c and the second metal lines 240a, 240b, and 240c are illustrated and described. However, without being limited thereto, one or more additional metal lines may be further formed on the second metal lines 240a, 240b, and 240c. In this case, the second metal lines 240a, 240b, and 240c may be formed of aluminum. At least some of the additional metal lines formed on the second metal lines 240a, 240b, and 240c may be formed of copper having a lower electrical resistivity than the aluminum of the second metal lines 240a, 240b, and 240c.

The interlayer insulating layer 215 may be disposed on the first substrate 210 and may include an insulating material, such as silicon oxide or silicon nitride.

Each of the first and second cell regions CELL1 and CELL2 may include at least one memory block. The first cell region CELL1 may include a second substrate 310 and a common source line 320. A plurality of word lines 330 (331 to 338) may be stacked on the second substrate 310 in a direction (the Z-axis direction) perpendicular to an upper surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (431 to 438) may be stacked in a direction (the Z-axis direction) perpendicular to an upper surface of the third substrate 410. The second substrate 310 and the third substrate 410 may be formed of various materials and may be, for example, silicon substrates, silicon-germanium substrates, germanium substrates, or substrates having mono-crystalline epitaxial layers grown on mono-crystalline silicon substrates. A plurality of channel structures CH may be formed in the first and second cell regions CELL1 and CELL2.

In an embodiment, as illustrated in A1, the channel structure CH may be provided in the bit line bonding region BLBA and may extend in the direction perpendicular to the upper surface of the second substrate 310 to penetrate the word lines 330, the string selection lines, and the ground selection line. The channel structure CH may include a data storage layer, a channel layer, and a buried insulating layer. The channel layer may be electrically connected with a first metal line 350c and a second metal line 360c in the bit line bonding region BLBA. For example, the second metal line 360c may be a bit line and may be connected to the channel structure CH through the first metal line 350c. The bit line 360c may extend in a first direction (a Y-axis direction) parallel to the upper surface of the second substrate 310.

In an embodiment, as illustrated in A2, the channel structure CH may include a lower channel LCH and an upper channel UCH connected to each other. For example, the channel structure CH may be formed through a process for the lower channel LCH and a process for the upper channel UCH. The lower channel LCH may extend in the direction perpendicular to the upper surface of the second substrate 310 and may penetrate the common source line 320 and the lower word lines 331 and 332. The lower channel LCH may include a data storage layer, a channel layer, and a buried insulating layer and may be connected with the upper channel UCH. The upper channel UCH may penetrate the upper word lines 333 to 338. The upper channel UCH may include a data storage layer, a channel layer, and a buried insulating layer, and the channel layer of the upper channel UCH may be electrically connected with the first metal line 350c and the second metal line 360c. As the length of a channel is increased, it may be difficult to form a channel having a constant width due to process reasons. The memory device 500 according to an embodiment of the present disclosure may include a channel having improved width uniformity through the lower channel LCH and the upper channel UCH formed by sequential processes.

When the channel structure CH includes the lower channel LCH and the upper channel UCH, as illustrated in A2, a word line located near the boundary between the lower channel LCH and the upper channel UCH may be a dummy word line. For example, the word line 332 and the word line 333 that form the boundary between the lower channel LCH and the upper channel UCH may be dummy word lines. In this case, data may not be stored in memory cells connected to the dummy word lines. Alternatively, the number of pages corresponding to the memory cells connected to the dummy word lines may be smaller than the number of pages corresponding to memory cells connected to normal word lines. A voltage level applied to the dummy word lines may differ from a voltage level applied to the normal word lines, and thus an influence of a non-uniform channel width between the lower channel LCH and the upper channel UCH on an operation of the memory device may be reduced.

Additionally, it is illustrated in A2 that the number of lower word lines 331 and 332 penetrated by the lower channel LCH is smaller than the number of upper word lines 333 to 338 penetrated by the upper channel UCH. However, this is illustrative, and the present disclosure is not limited thereto. In another example, the number of lower word lines penetrated by the lower channel LCH may be equal to or larger than the number of upper word lines penetrated by the upper channel UCH. Furthermore, the structure and connection relationship of the channel structure CH described above for the first cell region CELL1 may be applied identically to the channel structure CH in the second cell region CELL2.

In the bit line bonding region BLBA, a first through-electrode THV1 may be provided in the first cell region CELL1, and a second through-electrode THV2 may be provided in the second cell region CELL2. As illustrated in FIG. 22, the first through-electrode THV1 may penetrate the common source line 320 and the plurality of word lines 330. However, this is illustrative, and the first through-electrode THV1 may additionally penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In an embodiment, the first through-electrode THV1 and the second through-electrode THV2 may be electrically connected through a first through-metal pattern 372d and a second through-metal pattern 472d. The first through-metal pattern 372d may be formed on a lower side of the first upper chip including the first cell region CELL1, and the second through-metal pattern 472d may be formed on an upper side of the second upper chip including the second cell region CELL2. The first through-electrode THV1 may be electrically connected with the first metal line 350c and the second metal line 360c. A lower VIA 371d may be formed between the first through-electrode THV1 and the first through-metal pattern 372d, and an upper VIA 471d may be formed between the second through-electrode THV2 and the second through-metal pattern 472d. The first through-metal pattern 372d and the second through-metal pattern 472d may be connected by a bonding method.

Furthermore, in the bit line bonding region BLBA, an upper metal pattern 252 may be formed on the uppermost metal layer of the peripheral circuit region PERI, and an upper metal pattern 392 having the same shape as the upper metal pattern 252 may be formed on the uppermost metal layer of the first cell region CELL1. The upper metal pattern 392 of the first cell region CELL1 and the upper metal pattern 252 of the peripheral circuit region PERI may be electrically connected to each other by a bonding method. In the bit line bonding region BLBA, the bit line 360c may be electrically connected with a page buffer included in the peripheral circuit region PERI. For example, some of the circuit elements 220c of the peripheral circuit region PERI may provide a page buffer, and the bit line 360c may be electrically connected with the circuit elements 220c configuring the page buffer through an upper bonding metal 370c of the first cell region CELL1 and an upper bonding metal 270c of the peripheral circuit region PERI.

Still referring to FIG. 22, in the word line bonding region WLBA, the word lines 330 of the first cell region CELL1 may extend in a second direction (an X-axis direction) parallel to the upper surface of the second substrate 310 and may be connected with a plurality of cell contact plugs 340 (341 to 347). A first metal line 350b and a second metal line 360b may be sequentially connected to upper portions of the cell contact plugs 340 connected to the word lines 330. In the word line bonding region WLBA, the cell contact plugs 340 may be connected with the peripheral circuit region PERI through an upper bonding metal 370b of the first cell region CELL1 and an upper bonding metal 270b of the peripheral circuit region PERI.

The cell contact plugs 340 may be electrically connected with a row decoder included in the peripheral circuit region PERI. For example, some of the circuit elements 220b of the peripheral circuit region PERI may configure a row decoder, and the cell contact plugs 340 may be electrically connected with the circuit elements 220b configuring the row decoder through the upper bonding metal 370b of the first cell region CELL1 and the upper bonding metal 270b of the peripheral circuit region PERI. In an embodiment, an operating voltage of the circuit elements 220b that configure the row decoder may differ from an operating voltage of the circuit elements 220c that provide the page buffer. For example, the operating voltage of the circuit elements 220c that configure the page buffer may be greater than the operating voltage of the circuit elements 220b that configure the row decoder.

Likewise, in the word line bonding region WLBA, the word lines 430 of the second cell region CELL2 may extend in the second direction (the X-axis direction) parallel to the upper surface of the third substrate 410 and may be connected with a plurality of cell contact plugs 440 (441 to 447). The cell contact plugs 440 may be connected with the peripheral circuit region PERI through an upper metal pattern of the second cell region CELL2, a lower metal pattern and an upper metal pattern of the first cell region CELL1, and a cell contact plug 348.

In the word line bonding region WLBA, the upper bonding metal 370b may be formed in the first cell region CELL1, and the upper bonding metal 270b may be formed in the peripheral circuit region PERI. The upper bonding metal 370b of the first cell region CELL1 and the upper bonding metal 270b of the peripheral circuit region PERI may be electrically connected to each other by a bonding method. The upper bonding metal 370b and the upper bonding metal 270b may be formed of aluminum, copper, or tungsten.

In the external pad bonding region PA, a lower metal pattern 371e may be formed on a lower portion of the first cell region CELL1, and an upper metal pattern 472a may be formed on an upper portion of the second cell region CELL2. The lower metal pattern 371e of the first cell region CELL1 and the upper metal pattern 472a of the second cell region CELL2 may be connected by a bonding method in the external pad bonding region PA. Likewise, an upper metal pattern 372a may be formed on an upper portion of the first cell region CELL1, and an upper metal pattern 272a may be formed on an upper portion of the peripheral circuit region PERI. The upper metal pattern 372a of the first cell region CELL1 and the upper metal pattern 272a of the peripheral circuit region PERI may be connected to each other by a bonding method.

Common source line contact plugs 380 and 480 may be disposed in the external pad bonding region PA. The common source line contact plugs 380 and 480 may be formed of a conductive material, such as metal, a metal compound, or doped polysilicon. The common source line contact plug 380 of the first cell region CELL1 may be electrically connected with the common source line 320, and the common source line contact plug 480 of the second cell region CELL2 may be electrically connected with the common source line 420. A first metal line 350a and a second metal line 360a may be sequentially stacked on an upper portion of the common source line contact plug 380 of the first cell region CELL1, and a first metal line 450a and a second metal line 460a may be sequentially stacked on an upper portion of the common source line contact plug 480 of the second cell region CELL2.

Input/output pads 205, 405, and 406 may be disposed in the external pad bonding region PA. Referring to FIG. 22, a lower insulating layer 201 may cover a lower surface of the first substrate 210, and the first input/output pad 205 may be formed on the lower insulating layer 201. The first input/output pad 205 may be connected with at least one of the plurality of circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 and may electrically isolate the first input/output contact plug 203 from the first substrate 210.

An upper insulating layer 401 may be formed on the third substrate 410 to cover the upper surface of the third substrate 410. The second input/output pad 405 and/or the third input/output pad 406 may be disposed on the upper insulating layer 401. The second input/output pad 405 may be connected with at least one of the plurality of circuit elements 220a disposed in the peripheral circuit region PERI through second input/output contact plugs 403 and 303, and the third input/output pad 406 may be connected with at least one of the plurality of circuit elements 220a disposed in the peripheral circuit region PERI through third input/output contact plugs 404 and 304.

In an embodiment, the third substrate 410 may not be disposed in the regions in which the input/output contact plugs are disposed. For example, as illustrated in B1 and B2, the third input/output contact plug 404 may be separated from the third substrate 410 in a direction parallel to the upper surface of the third substrate 410, may penetrate an interlayer insulating layer 415 of the second cell region CELL2, and may be connected to the third input/output pad 406. In this case, the third input/output contact plug 404 may be formed through various processes.

For example, as illustrated in B1, the third input/output contact plug 404 may extend in the third direction (the Z-axis direction) and may have an increasing diameter toward the upper insulating layer 401. In other words, while the channel structure CH described with reference to A1 has a decreasing diameter toward the upper insulating layer 401, the third input/output contact plug 404 may have an increasing diameter toward the upper insulating layer 401. For example, the third input/output contact plug 404 may be formed after the second cell region CELL2 and the first cell region CELL1 are coupled by a bonding method.

For example, as illustrated in B2, the third input/output contact plug 404 may extend in the third direction (the Z-axis direction) and may have a decreasing diameter toward the upper insulating layer 401. In other words, similar to the channel structure CH, the third input/output contact plug 404 may have a decreasing diameter toward the upper insulating layer 401. For example, the third input/output contact plug 404 may be formed together with the cell contact plugs 440 before the second cell region CELL2 and the first cell region CELL1 are coupled by a bonding method.

In an embodiment, an input/output contact plug may be disposed to overlap the third substrate 410. For example, as illustrated in C1-C3, the second input/output contact plug 403 may be formed through the interlayer insulating layer 415 of the second cell region CELL2 in the third direction (the Z-axis direction) and may be electrically connected to the second input/output pad 405 through the third substrate 410. In this case, a connection structure of the second input/output contact plug 403 and the second input/output pad 405 may be implemented in various ways.

For example, as illustrated in C1, an opening 408 may be formed through the third substrate 410, and the second input/output contact plug 403 may be directly connected to the second input/output pad 405 through the opening 408 formed in the third substrate 410. In this case, as illustrated in C1, the second input/output contact plug 403 may have an increasing diameter toward the second input/output pad 405. However, this is illustrative, and the second input/output contact plug 403 may have a decreasing diameter toward the second input/output pad 405.

For example, as illustrated in C2, the opening 408 may be formed through the third substrate 410, and a contact 407 may be formed in the opening 408. A first end portion of the contact 407 may be connected to the second input/output pad 405, and a second end portion (opposite the first end portion) of the contact 407 may be connected to the second input/output contact plug 403. Accordingly, the second input/output contact plug 403 may be electrically connected to the second input/output pad 405 through the contact 407 in the opening 408. In this case, as illustrated in C2, the contact 407 may have an increasing diameter toward the second input/output pad 405, and the second input/output contact plug 403 may have a decreasing diameter toward the second input/output pad 405. For example, the third input/output contact plug 403 may be formed together with the cell contact plugs 440 before the second cell region CELL2 and the first cell region CELL1 are coupled by a bonding method, and the contact 407 may be formed after the second cell region CELL2 and the first cell region CELL1 are coupled by the bonding method.

For example, as illustrated in C3, a stopper 409 may be additionally formed on an upper surface of the opening 408 of the third substrate 410. The stopper 409 may be a metal line formed on the same layer as the common source line 420. However, this is illustrative, and the stopper 409 may be a metal line formed on the same layer as at least one of the word lines 430. The second input/output contact plug 403 may be electrically connected to the second input/output pad 405 through the contact 407 and the stopper 409.

Similar to the second and third input/output contact plugs 403 and 404 of the second cell region CELL2, the second and third input/output contact plugs 303 and 304 of the first cell region CELL1 may have a decreasing diameter toward the lower metal pattern 371e, or may have an increasing diameter toward the lower metal pattern 371e.

Additionally, in some embodiments, a slit 411 may be formed in the third substrate 410. For example, the slit 411 may be formed at any position in the external pad bonding region PA. For example, as illustrated in D1-D3, the slit 411 may be located between the second input/output pad 405 and the cell contact plugs 440 when viewed on a plane. However, this is illustrative, and the slit 411 may be formed such that the second input/output pad 405 is located between the slit 411 and the cell contact plugs 440 when viewed on the plane.

For example, as illustrated in D1, the slit 411 may be formed through the third substrate 410. For example, the slit 411 may help prevent fine cracks in the third substrate 410 during the formation of the opening 408. However, this is illustrative, and the slit 411 may be formed to have a depth ranging from about 60% to about 70% of the thickness of the third substrate 410.

For example, as illustrated in D2, a conductive material 412 may be formed in the slit 411. For example, the conductive material 412 may be used to discharge a leakage current generated while circuit elements in the external pad bonding region PA are driven. In this case, the conductive material 412 may be connected to an external ground line.

For example, as illustrated in D3, an insulating material 413 may be formed in the slit 411. For example, the insulating material 413 may be formed to electrically isolate the second input/output pad 405 and the second input/output contact plug 403 disposed in the external pad bonding region PA from the word line bonding region WLBA. The formation of the insulating material 413 in the slit 411 may interrupt the influence of the voltage provided through the second input/output pad 405 on the metal layer located on the third substrate 410 in the word line bonding region WLBA.

In some embodiments, the first to third input/output pads 205, 405, and 406 may be selectively formed. For example, the memory device 500 may be implemented to include only the first input/output pad 205 disposed on the first substrate 201, only the second input/output pad 405 disposed on the third substrate 410, or only the third input/output pad 406 disposed on the upper insulating layer 401.

Additionally, in some embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the peripheral circuit region PERI and the first cell region CELL1 are bonded to each other, and an insulating layer for covering an upper surface of the common source line 320 or a conductive layer for connection may be formed. Similarly, the third substrate 410 of the second cell region CELL2 may be removed before or after the first cell region CELL1 and the second cell region CELL2 are bonded to each other, and the upper insulating layer 401 for covering an upper surface of the common source line 420 or a conductive layer for connection may be formed.

In an embodiment, an EPI timer and an EPI table according to an embodiment of the present disclosure may be formed in the peripheral circuit region PERI. In an embodiment, CA signal pins for the SCA NAND interface may be implemented through the input/output pads 205, 405, and 406, and the EPI information INF EPI may be provided to an external controller through the input/output pads 205, 405, and 406.

According to the present disclosure, a memory device may manage an erase left-alone time (or an erase to program interval (EPI) time) of a memory block. When an EPI time exceeds a reference time, the memory device may transmit EPI information to a controller, allowing the controller to perform a program operation or a close operation on the memory block based on the EPI information. In this case, even if the controller has limited resources or lacks an EPI-related function, the deterioration of data due to the delay of the EPI time may be prevented. Additionally, the EPI information may be provided from the memory device to the controller through a command/address channel. This enables the development of a memory device with improved reliability and performance, a storage device including the memory device, and an operation method of the memory device.

While the present disclosure has been described with reference to embodiments thereof, it will be apparent to those of ordinary skill in the art that various changes and modifications can be made without departing from the spirit and scope of the present disclosure as set forth in the following claims.

## Claims

1. A memory device comprising:
a memory cell array including a first memory block;
a control logic circuit configured to receive an erase command from an external controller and to control an erase operation on the first memory block in response to the erase command;
an erase to program interval (EPI) timer configured to begin measuring a first EPI time of the first memory block in response to the erase command; and
a memory circuit configured to store an EPI table that stores the first EPI time,
wherein, when the first EPI time exceeds a reference time, the control logic circuit is further configured to provide EPI information to the external controller.

2. The memory device of claim 1, wherein the first memory block includes a plurality of memory cells, and each of the plurality of memory cells is a NAND flash memory cell.

3. The memory device of claim 1, wherein, upon completion of programming a last word line of the first memory block, the EPI timer is further configured to clear the first EPI time from the EPI table.

4. The memory device of claim 1, wherein, when a command for the first memory block is not received within a specified time from a time the EPI information is provided to the external controller, the control logic circuit is further configured to perform a close operation on the first memory block.

5. The memory device of claim 4, wherein the control logic circuit is further configured to transmit close information, indicating that the close operation on the first memory block has been performed, to the external controller.

6. The memory device of claim 1, wherein the control logic circuit is further configured to:
receive a first command from the external controller; and
transmit the EPI information to the external controller in response to the first command, and
wherein the first command is a status read command, a get feature command, or a vendor command.

7. The memory device of claim 1, wherein the control logic circuit is further configured to receive the erase command through a command/address channel.

8. The memory device of claim 7, wherein the control logic circuit is further configured to:
receive a program command for the first memory block from the external controller through the command/address channel;
receive data from the external controller through an input/output channel; and
program the data in the first memory block in response to the program command, and
wherein the command/address channel and the input/output channel are physically separated from each other.

9. The memory device of claim 8, wherein the control logic circuit is further configured to transmit the EPI information to the external controller through the command/address channel.

10. The memory device of claim 9, wherein, while the data are being transmitted from the external controller to the memory device through the input/output channel, the control logic circuit transmits the EPI information to the external controller through the command/address channel.

11. A storage device comprising:
a memory device including a first memory block; and
a controller configured to control the memory device,
wherein the memory device is configured to:
perform an erase operation on the first memory block in response to an erase command received from the controller;
begin measuring a first erase to program interval (EPI) time of the first memory block in response to the erase command; and
transmit EPI information to the controller when the first EPI time exceeds a reference time, and
wherein the controller is further configured to perform a program operation on the first memory block or a close operation on the first memory block in response to the EPI information.

12. The storage device of claim 11, wherein the controller and the memory device communicate with each other through a command/address channel and an input/output channel.

13. The storage device of claim 12, wherein the controller is configured to transmit the erase command to the memory device through the command/address channel.

14. The storage device of claim 13, wherein the controller is configured to:
transmit a program command for the first memory block to the memory device through the command/address channel; and
transmit data to be programmed in the first memory block to the memory device through the input/output channel, and
wherein the controller is further configured to program the data received through the input/output channel in the first memory block in response to the program command received through the command/address channel.

15. The storage device of claim 14, wherein, while the data are being received through the input/output channel, the memory device is further configured to provide the EPI information to the controller through the command/address channel.
